# EUROPEAN PATENT APPLICATION

(11) **EP 4 550 965 A1**
(43) Date of publication of application: **07.05.2025**
(21) Application number: 24808839.5
(22) Date of filing: 04.06.2024
(51) Int. Cl.: H10B 12/00

(54) **SEMICONDUCTOR STRUCTURE AND MANUFACTURING METHOD THEREFOR**

(30) Priority: 20.09.2023 CN 202311222778
(71) Applicant: CXMT Corporation, Hefei City, Anhui Province 230601 (CN)
(72) Inventor: WU, Nan, Hefei, Anhui 230601 (CN)
(74) Representative: Gulde & Partner
(86) International application number: PCT/CN2024/097228
(87) International publication number: WO 2025/060498

(57) **Abstract**

A semiconductor structure and a method for manufacturing same are provided. The semiconductor structure includes: a substrate; a memory cell group on the substrate; and a first conductive structure. The memory cell group includes a plurality of vertically stacked memory cells, each one of the plurality of memory cells includes a transistor and a capacitor, and the capacitor extends along a first direction parallel to the substrate. The first conductive structure is located on a first side surface of the memory cell group, where the first conductive structure and the memory cell group are arranged along a second direction parallel to the substrate, the first conductive structure extends along a third direction perpendicular to the substrate, the first conductive structure is coupled to a plurality of capacitors in the memory cell group, and the first direction and the second direction intersect with each other. The present disclosure can at least help to reduce a length of the semiconductor structure in the first direction and increase integration density of the semiconductor structure.

## Description

### CROSS-REFERENCE TO RELATED APPLICATIONS

The present disclosure claims priority to Chinese Patent Application No. 202311222778.2 filed on September 20, 2023 and entitled "SEMICONDUCTOR STRUCTURE AND METHOD FOR MANUFACTURING SAME", the content of which is incorporated herein by reference in its entirety.

### TECHNICAL FIELD

Embodiments of the present disclosure relate to the technical field of semiconductors, in particular to a semiconductor structure and a method for manufacturing the same.

### BACKGROUND

With continuous development of semiconductor structures, the critical dimension of a semiconductor structure becomes increasingly smaller. However, due to the limitation of the lithography machine, there is a limit with regard to reducing the critical dimension. Therefore, many researchers and semiconductor industry professionals focus on studying how to produce chips with higher memory density on a wafer. In a two-dimensional or planar semiconductor device, all memory cells are arranged horizontally, and therefore, the integration density of the two-dimensional or planar semiconductor device may depend on the area occupied by each of the memory cells, and the integration density of the two-dimensional or planar semiconductor device is greatly affected by the technique used for forming a fine pattern. Consequently, there is a limit with regard to the continuous increase in the integration density of the two-dimensional or planar semiconductor device. Therefore, semiconductor devices are becoming three-dimensional.

However, in a three-dimensional semiconductor device, how to arrange more memory cells in a limited arrangement space is yet to be studied.

### SUMMARY

Embodiments of the present disclosure provide a semiconductor structure and a method for manufacturing same, which at least helps to reduce a length of the semiconductor structure in a first direction and increase integration density of the semiconductor structure.

According to some embodiments of the present disclosure, in one aspect, the embodiments of the present disclosure provide a semiconductor structure including: a substrate; a memory cell group on the substrate, where the memory cell group includes a plurality of vertically stacked memory cells, each one of the plurality of memory cells includes a transistor and a capacitor, and the capacitor extends along a first direction parallel to the substrate; and a first conductive structure located on a first side surface of the memory cell group, where the first conductive structure and the memory cell group are arranged along a second direction parallel to the substrate, the first conductive structure extends along a third direction perpendicular to the substrate, the first conductive structure is coupled to a plurality of capacitors in the memory cell group, and the first direction and the second direction intersect with each other.

In some embodiments, a plurality of memory cell groups and a plurality of first conductive structures are alternately arranged along the second direction; each one of the plurality of first conductive structures is located on a first side surface of at least one of the plurality of memory cell groups, and each one of the plurality of memory cell groups is in contact with at least one of the plurality of first conductive structures.

In some embodiments, the first conductive structure is plate-shaped, and the first conductive structure extends along the first direction and the third direction.

In some embodiments, at least one of the first conductive structures is coupled to capacitors of two of the plurality of memory cell groups respectively on two sides of the first conductive structure.

In some embodiments, a second height of the first conductive structure along the third direction is greater than a first height of the memory cell group along the third direction; the semiconductor structure further includes: a first isolation layer, where the first isolation layer covers at least a top of the memory cell group, and the first conductive structure is adjacent to the first isolation layer.

In some embodiments, the capacitor includes a first electrode, and the first electrode extends along the first direction; the semiconductor structure further includes a first dielectric layer, where the first dielectric layer is located between the first conductive structure and the first electrode.

In some embodiments, the semiconductor structure further includes a conductive protrusion part protruding from a sidewall of the first conductive structure and sandwiched between first electrodes adjacent to each other in the third direction; the first dielectric layer is also located between the conductive protrusion part and the first electrode.

In some embodiments, the first electrode is a cup-shaped structure with an opening toward the first direction, and the semiconductor structure further includes: first conductive parts extending along the first direction, where the first conductive parts are in a one-to-one correspondence with the first electrodes, passing through the opening, and are respectively embedded in the first electrodes; a second dielectric layer located between the first conductive parts and the first electrodes; and a second conductive structure located on a second side surface of the memory cell group, where the second conductive structure and the memory cell group are arranged along the first direction, the second conductive structure extends along the third direction, the second conductive structure is electrically connected to the first conductive parts, and the second dielectric layer is also located on a sidewall of the second conductive structure.

In some embodiments, the second conductive structure is in contact with all the first conductive parts; or a plurality of second conductive structures are spaced apart along the second direction, and each one of the plurality of second conductive structures is in contact with a plurality of first conductive parts spaced apart along the third direction.

In some embodiments, the semiconductor structure further includes second conductive parts, where the second conductive parts extend along the second direction and are spaced apart along the third direction, the second conductive parts each have a third side surface and a fourth side surface opposite to each other along the first direction, the third side surface is in contact with a plurality of first conductive parts spaced apart along the second direction, and the fourth side surface is in contact with the second conductive structure; the second dielectric layer also covers a sidewall of the second conductive part.

In some embodiments, the memory cell groups are also spaced apart along the first direction, the first conductive parts are also spaced apart along the first direction, the first conductive parts adjacent to each other along the first direction are in contact with a same second conductive structure, and two adjacent memory cell groups spaced apart along the first direction are arranged in mirror symmetry along the second conductive structure.

In some embodiments, the first electrode is a columnar structure extending along the first direction, and the first dielectric layer covers at least a part of a sidewall of the first electrode parallel to the first direction.

In some embodiments, a part of the first conductive structure along the third direction is embedded in the substrate.

In some embodiments, the semiconductor structure further includes a first electrical connection layer, where the first electrical connection layer is electrically connected to a plurality of first conductive structures spaced apart along the second direction, and the first electrical connection layer is located above the plurality of first conductive structures.

In some embodiments, along the first direction, a first length of the first conductive structure is less than a second length of the first electrode; the semiconductor structure further includes a second isolation layer, where the second isolation layer is located on at least one side of the first conductive structure along the first direction, and the second isolation layer is in contact with a sidewall of the first electrode.

In some embodiments, the semiconductor structure further includes: a first conductive plug located on the first conductive structure and electrically connected to the first conductive structure; a second conductive plug located on the second conductive structure and electrically connected to the second conductive structure; and a second electrical connection layer located on the first conductive plug and the second conductive plug and electrically connected to the first conductive plug and the second conductive plug.

In some embodiments, the transistor includes a semiconductor layer extending along the first direction, the semiconductor layer includes a first surface and a second surface directly opposite to each other along the first direction, and the first surface is in contact with the capacitor; the semiconductor structure further includes: a bit line structure in contact with the second surface; and a word line structure located on a side surface of the semiconductor layer, where the word line structure extends along the second direction, and the bit line structure extends along the third direction; or the word line structure extends along the third direction, and the bit line structure extends along the second direction.

According to some embodiments of the present disclosure, in another aspect, the embodiments of the present disclosure further provide a method for manufacturing a semiconductor structure, which includes: providing a substrate; forming a memory cell group on the substrate, where the memory cell group includes a plurality of vertically stacked memory cells, each one of the plurality of memory cells includes a transistor and a capacitor, and the capacitor extends along a first direction parallel to the substrate; and forming a first conductive structure located on a first side surface of the memory cell group, where the first conductive structure and the memory cell group are arranged along a second direction parallel to the substrate, the first conductive structure extends along a third direction perpendicular to the substrate, the first conductive structure is coupled to a plurality of capacitors in the memory cell group, and the first direction and the second direction intersect with each other.

In some embodiments, forming the memory cell group on the substrate includes: forming a stack structure on the substrate, where the stack structure includes first sacrificial layers and second sacrificial layers alternately stacked along the third direction; patterning the second sacrificial layer to form capacitor grooves extending along the first direction, where the plurality of capacitor grooves are spaced apart along at least the second direction; forming first electrodes respectively in the capacitor grooves, where a plurality of first electrodes are spaced apart along the second direction and the third direction, and the first direction and the second direction intersect with each other and are both parallel to the substrate; and forming a first dielectric layer, where the first dielectric layer is located on a sidewall of the first electrode, where after the first conductive structure is formed, the first conductive structure comes in contact with the first dielectric layer.

In some embodiments, forming the first conductive structure includes: etching the stack structure to form a first through hole penetrating through the stack structure in the third direction, where the first through hole is located between the first electrodes adjacent to each other along the second direction; and forming the first conductive structure in the first through hole.

In some embodiments, the first through hole exposes a sidewall of the first electrode and a sidewall of the first sacrificial layer, and the manufacturing method further includes: performing lateral etching along the first through hole to remove the first sacrificial layer exposed by the first through hole and form an intercommunication groove, where the intercommunication groove is located between the first electrodes adjacent to each other along the third direction, and the intercommunication groove is in communication with two first through holes adjacent to each other along the second direction, where the formed first dielectric layer further covers an inner wall of the intercommunication groove; the step of forming the first conductive structure in the first through hole further includes: forming a conductive protrusion part in the intercommunication groove.

In some embodiments, patterning the second sacrificial layer includes: etching the stack structure to form a second through hole passing through the stack structure in the third direction, where the second through hole exposes the first sacrificial layer and the second sacrificial layer; and performing lateral etching along the second through hole to remove a part of the second sacrificial layer and form the capacitor grooves; forming the first electrodes respectively in the capacitor grooves includes: forming the first electrodes conformally covering inner walls of the capacitor grooves, respectively, where the first electrode is a cup-shaped structure with an opening toward the first direction; the manufacturing method further includes: forming a second dielectric layer conformally covering at least an inner wall of the first electrode; and forming first conductive parts and a second conductive structure on a surface of the second dielectric layer, where the first conductive parts are in a one-to-one correspondence with the first electrodes, passing through the opening, and are respectively embedded in the first electrodes, and the second conductive structure fills up the second through hole.

In some embodiments, a plurality of first through holes are spaced apart at least along the second direction; after the first conductive structure is formed in the first through hole, the manufacturing method further includes: forming a first electrical connection layer on top surfaces of a plurality of first conductive structures, where the first electrical connection layer is electrically connected to a plurality of first conductive structures spaced apart along the second direction.

The technical solutions provided according to the embodiments of the present disclosure at least have the following advantages:
A column of memory cells stacked along the third direction form one memory cell group, and a plurality of memory cell groups are spaced apart along the second direction to form a three-dimensional semiconductor structure. Based on this, a first conductive structure is arranged between memory cell groups adjacent to each other along the second direction, and the first conductive structure is coupled to a plurality of capacitors in at least one of the memory cell groups. It can be understood that, a part of the first conductive structure may function as a conductive plate electrode of the capacitor, for example, an upper electrode of the capacitor, that is, the first conductive structure and the plurality of capacitors coupled thereto can form a capacitor structure. In this case, a structure for storing data in each memory cell includes the capacitor and part of the first conductive structure coupled to the memory cell, thereby helping to increase a capacitance of the capacitor structure for storing data corresponding to each memory cell by arranging the first conductive structure and thereby increase a capacitance of the memory cell group.

In addition, in one aspect, the first conductive structure is arranged between the memory cell groups adjacent to each other along the second direction, so that an added first conductive structure does not increase a length of the semiconductor structure along the first direction, and the first conductive structure is located in the isolation layer originally arranged for isolating adjacent memory cell groups and thus does not occupy an extra arrangement space in the semiconductor structure, thereby helping to reduce the length of the semiconductor structure in the first direction and increase the integration density of the semiconductor structure; in another aspect, the first conductive structure extends along the third direction, and it can be understood that the first conductive structure may be manufactured along a direction perpendicular to the substrate, that is, a vertical direction, and the manufacturing process is simple, so that a precise dimension of the first conductive structure can be easily controlled, thus improving electrical performance of the semiconductor structure.

### BRIEF DESCRIPTION OF THE DRAWINGS

One or more embodiments are illustrated by pictures in corresponding drawings, and the exemplary illustration is not to be construed as limiting the embodiments. Elements with a same reference numeral represent similar elements. Unless otherwise specified, the pictures in the drawings do not constitute limitations in terms of scale. For clearer illustration of the technical solutions in the embodiments of the present disclosure or a conventional technology, the drawings required to be used in the embodiments are briefly described below. It is clear that the drawings in the description below are only some embodiments of the present disclosure, and for those of ordinary skill in the art, other drawings can be obtained according to these drawings without creative efforts.
FIG. 1 is a schematic diagram showing a partial three-dimensional structure of a semiconductor structure provided according to an embodiment of the present disclosure;
(a) in FIG. 2 is a schematic diagram showing a partial cross-sectional structure of the semiconductor structure shown in FIG. 1 along a first cross-sectional direction AA1;

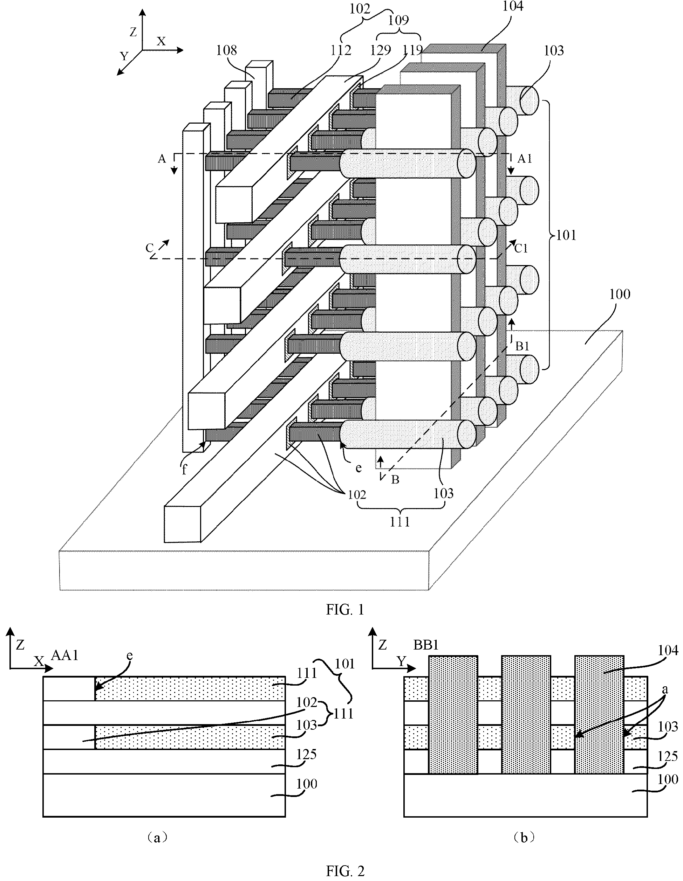

(b) in FIG. 2 is a schematic diagram showing a partial cross-sectional structure of the semiconductor structure shown in FIG. 1 along a second cross-sectional direction BB1;

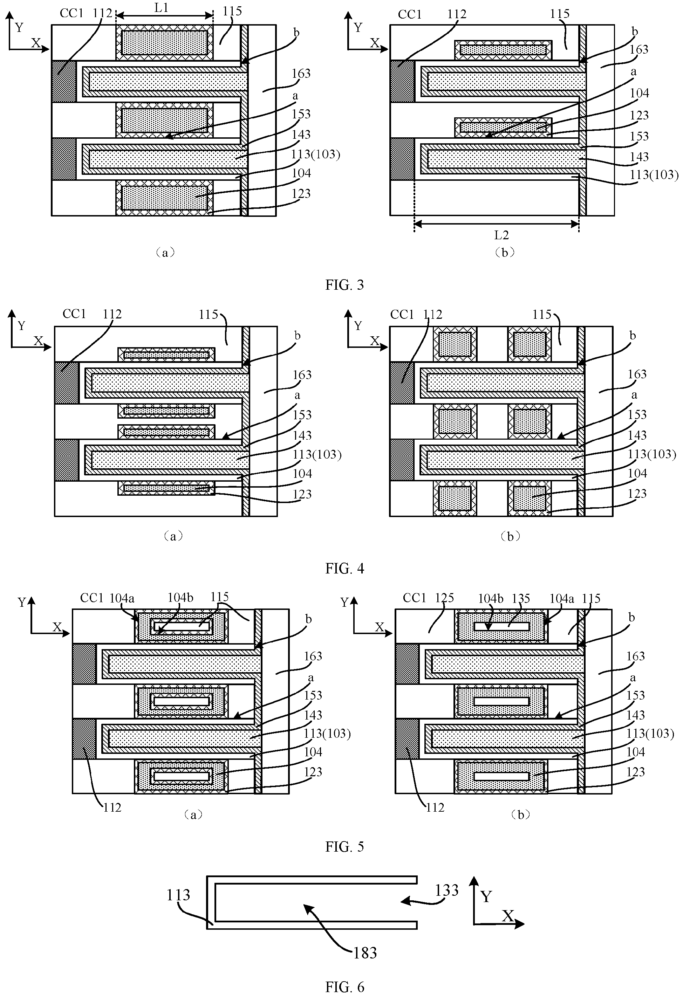

FIG. 3 is a schematic structural diagram showing two partial cross-sectional structures of the semiconductor structure shown in FIG. 1 along a third cross-sectional direction CC1;
FIG. 4 is a schematic diagram showing another two partial cross-sectional structures of the semiconductor structure shown in FIG. 1 along the third cross-sectional direction CC1;
FIG. 5 is a schematic diagram showing still another two partial cross-sectional structures of the semiconductor structure shown in FIG. 1 along the third cross-sectional direction CC1;
FIG. 6 is a schematic diagram showing a partial cross-sectional structure of the first electrode in the semiconductor structure shown in FIG. 3 to FIG. 5;

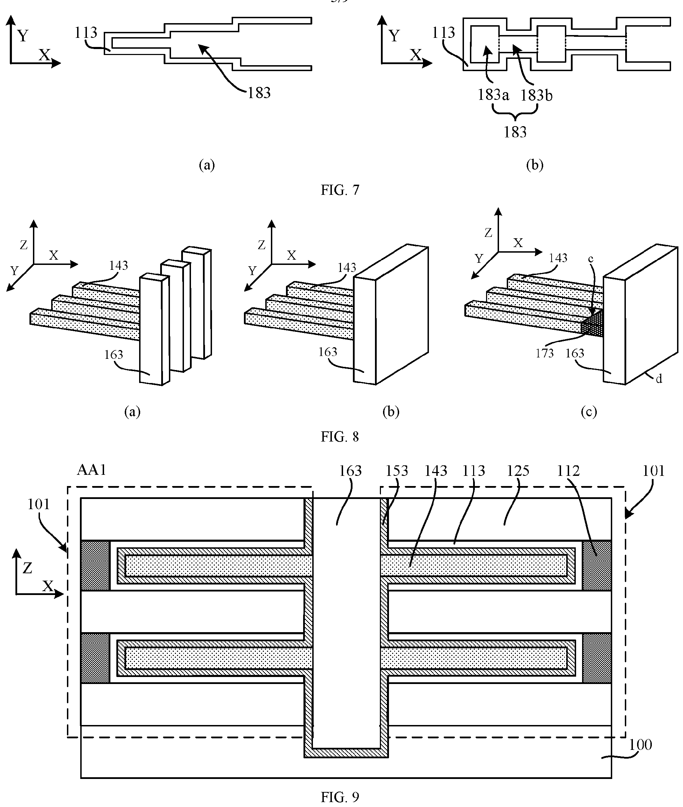

FIG. 7 is a schematic diagram showing another two partial cross-sectional structures of a first electrode in a semiconductor structure provided according to an embodiment of the present disclosure;
FIG. 8 is a schematic diagram showing three partial three-dimensional structures of a semiconductor structure provided according to an embodiment of the present disclosure;
FIG. 9 to FIG. 12 are schematic diagrams showing another four partial cross-sectional structures of a semiconductor structure provided according to an embodiment of the present disclosure along the first cross-sectional direction AA1;

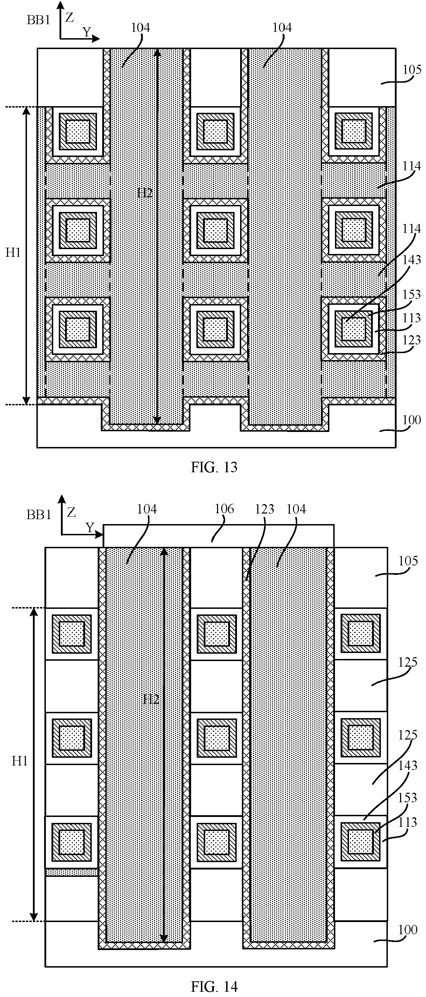

FIG. 13 and FIG. 14 are schematic diagrams showing another two partial cross-sectional structures of a semiconductor structure provided according to an embodiment of the present disclosure along the second cross-sectional direction BB1;

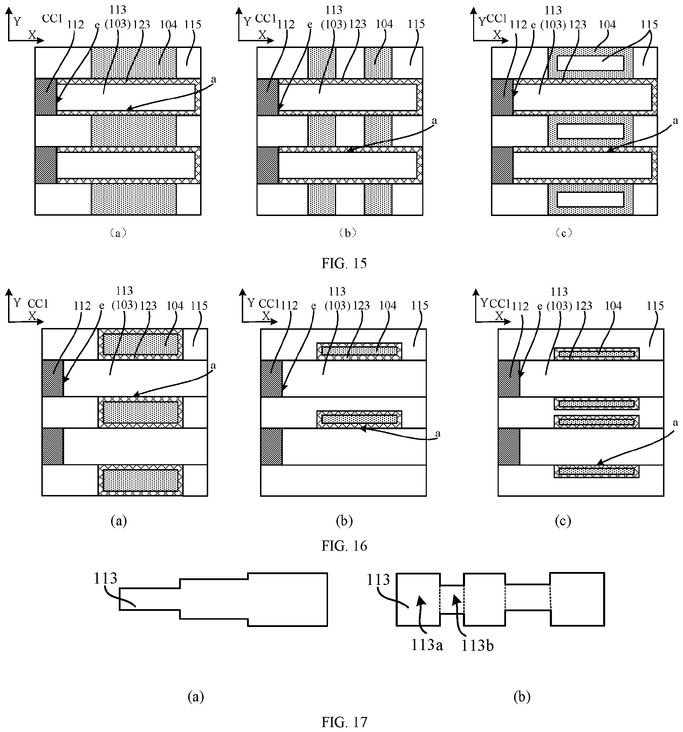

FIG. 15 is a schematic structural diagram showing three partial cross-sectional structures of the semiconductor structure shown in FIG. 1 along the third cross-sectional direction CC1;
FIG. 16 is a schematic diagram showing another three partial cross-sectional structures of the semiconductor structure shown in FIG. 1 along the third cross-sectional direction CC1;
FIG. 17 is a schematic diagram showing another two partial cross-sectional structures of a first electrode in a semiconductor structure provided according to an embodiment of the present disclosure;

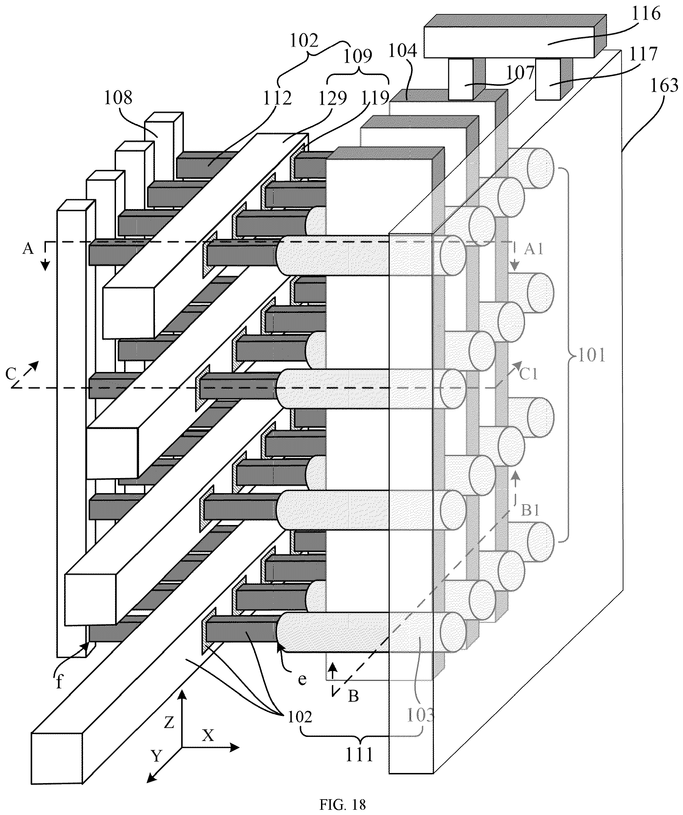

FIG. 18 is a schematic diagram showing another partial three-dimensional structure of a semiconductor structure provided according to an embodiment of the present disclosure;

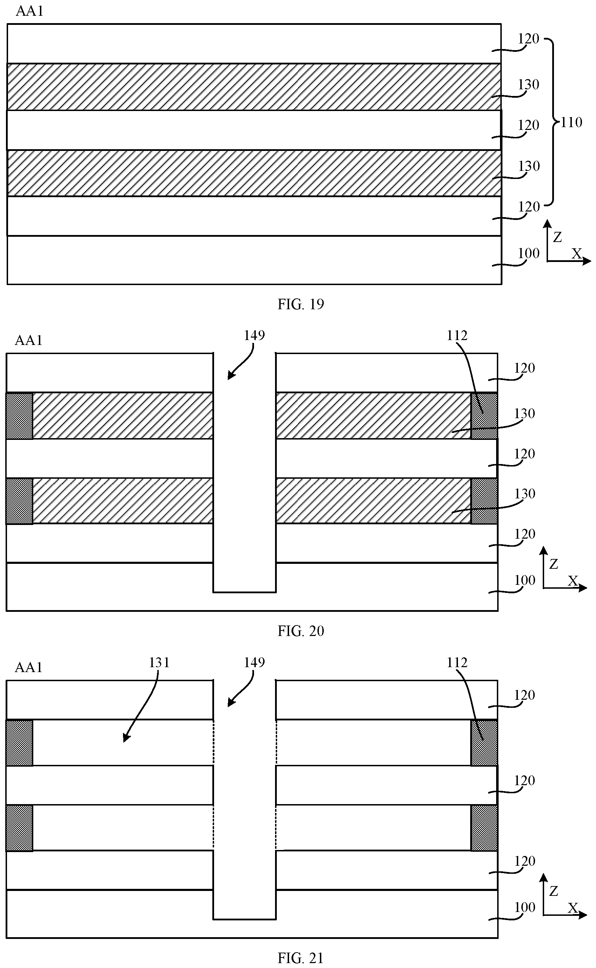

FIG. 19 to FIG. 23 are schematic diagrams showing cross-sectional structures corresponding to steps in a method for manufacturing a semiconductor structure provided according to another embodiment of the present disclosure.

### DETAILED DESCRIPTION

As is known from the background, the integration density of a three-dimensional semiconductor structure needs to be increased.

The present disclosure provides a semiconductor structure and a method for manufacturing same. In the semiconductor structure, based on constructing a three-dimensional semiconductor structure, a first conductive structure is arranged between memory cell groups adjacent to each other along the second direction, and the first conductive structure is coupled to a plurality of capacitors in at least one of the memory cell groups. In this case, a structure for storing data in each memory cell includes the capacitor and part of the first conductive structure coupled to the memory cell, thereby helping to increase a capacitance of the capacitor structure for storing data corresponding to each memory cell by arranging the first conductive structure and thereby increase a capacitance of the memory cell group. In addition, in one aspect, the first conductive structure is arranged between the memory cell groups adjacent to each other along the second direction, so that an added first conductive structure does not increase a length of the semiconductor structure along the first direction, and a space occupied by the first conductive structure is a part of a space of an isolation layer arranged for isolating adjacent memory cell groups and thus the first conductive structure does not occupy an extra arrangement space in the semiconductor structure, thereby helping to reduce the length of the semiconductor structure in the first direction and increase the integration density of the semiconductor structure; in another aspect, the first conductive structure extends along the third direction, and thus the first conductive structure may be manufactured along a vertical direction, and the manufacturing process is simple, so that a precise dimension of the first conductive structure can be easily controlled, thus improving electrical performance of the semiconductor structure.

The embodiments of the present disclosure are described in detail below with reference to the drawings. However, those of ordinary skill in the art can understand that in the embodiments of the present disclosure, numerous technical details are set forth in order to enable readers to better understand the embodiments of the present disclosure. However, the technical solutions claimed by the embodiments of the present disclosure can also be implemented even without these technical details and the various changes and modifications based on the following embodiments.

An embodiment of the present disclosure provides a semiconductor structure. The semiconductor structure provided according to this embodiment of the present disclosure is described in detail below with reference to the drawings.

Referring to FIG. 1 and FIG. 2, the semiconductor structure includes: a substrate 100; a memory cell group 101 on the substrate 100, where the memory cell group 101 includes a plurality of vertically stacked memory cells 111, each one of the plurality of memory cells 111 includes a transistor 102 and a capacitor 103, and the capacitor 103 extends along a first direction X parallel to the substrate 100; and a first conductive structure 104 located on a first side surface a of the memory cell group 101, where the first conductive structure 104 and the memory cell group 101 are arranged along a second direction Y parallel to the substrate 100, the first conductive structure 104 extends along a third direction Z perpendicular to the substrate 100, the first conductive structure 104 is coupled to a plurality of capacitors 103 in the memory cell group 101, and the first direction X and the second direction Y intersect with each other.

It should be noted that, FIG. 1 is a schematic diagram showing a partial three-dimensional structure of a semiconductor structure provided according to an embodiment of the present disclosure, (a) in FIG. 2 is a schematic diagram showing a partial cross-sectional structure of the semiconductor structure shown in FIG. 1 along a first cross-sectional direction AA1, and (b) in FIG. 2 is a schematic diagram showing a partial cross-sectional structure of the semiconductor structure shown in FIG. 1 along a second cross-sectional direction BB1. In addition, in FIG. 1, to show the appearance of the first conductive structure 104 in a three-dimensional space, a same filling manner is applied to a top surface and a side surface perpendicular to the first direction X of the first conductive structure 104, and different filling manners are applied to the side surface perpendicular to the first direction X and a side surface perpendicular to the second direction Y of the first conductive structure 104.

In some embodiments, referring to FIG. 2, the first side surface a of the memory cell group 101 is perpendicular to the second direction Y, and a same first side surface a includes side surfaces of a plurality of capacitors 103 arranged along the third direction Z. One memory cell group 101 may have two first side surfaces a arranged opposite to each other along the second direction Y. A position relationship between the first conductive structure 104 and the memory cell group 101 is described in detail subsequently with reference to a plurality of embodiments.

It should be noted that, in FIG. 1, an example in which one memory cell group 101 includes four memory cells 111 stacked along the third direction Z is shown, and in FIG. 2, an example in which one memory cell group 101 includes two memory cells 111 stacked along the third direction Z is shown. In practical application, the quantity of memory cells 111 stacked along the third direction Z and included in one memory cell group 101 is not limited, and the quantity of vertically stacked memory cells 111 may be three, five, eight, or the like. In addition, in FIG. 1, an example in which four memory cell groups 101 are arranged along the second direction Y is shown. In practical application, the quantity of memory cell groups 101 arranged along the second direction Y is not limited and may be, for example, two, five, eight, or the like.

It can be understood that, a column of memory cells 111 stacked along the third direction Z form one memory cell group 101, and a plurality of memory cell groups 101 are spaced apart along the second direction Y to form a three-dimensional semiconductor structure. Based on this, a first conductive structure 104 is arranged between memory cell groups 101 adjacent to each other along the second direction Y, and the first conductive structure 104 is coupled to a plurality of capacitors 103 in at least one of the memory cell groups 101. It can be understood that, a part of the first conductive structure 104 may function as a conductive plate electrode of the capacitor 103, for example, an upper electrode of the capacitor 103, that is, the first conductive structure 104 and the plurality of capacitors 103 coupled thereto can form a capacitor structure. In this case, a structure for storing data in each memory cell 111 includes the capacitor 103 and part of the first conductive structure 104 coupled to the memory cell 111, thereby helping to increase a capacitance of the capacitor structure for storing data corresponding to each memory cell 111 by arranging the first conductive structure 104 and thereby increase a capacitance of the memory cell group 101.

In addition, in one aspect, the first conductive structure 104 is arranged between the memory cell groups 101 adjacent to each other along the second direction Y, so that an added first conductive structure 104 does not increase a length of the semiconductor structure along the first direction X, and a space occupied by the first conductive structure 104 is a part of a space of an isolation layer originally arranged for isolating adjacent memory cell groups 101, thereby helping to reduce the length of the semiconductor structure in the first direction X and increase the integration density of the semiconductor structure; in another aspect, the first conductive structure 104 extends along the third direction Z, and it can be understood that the first conductive structure 104 may be manufactured along a direction perpendicular to the substrate 100, that is, a vertical direction, and the manufacturing process is simple, so that a precise dimension of the first conductive structure 104 can be easily controlled, thus improving electrical performance of the semiconductor structure.

Embodiments of the present disclosure are described in more detail below with reference to the drawings.

In some embodiments, referring to FIG. 1 and FIG. 2, the transistor 102 includes a semiconductor layer 112 extending along the first direction X. The semiconductor layer 112 includes a first surface e and a second surface f directly opposite to each other along the first direction X, and the first surface e is in contact with the capacitor 103. The semiconductor structure further includes a bit line structure 108 in contact with the second surface f and a word line structure 109 located on a side surface of the semiconductor layer 112.

In some embodiments, referring to FIG. 1, the word line structure 109 extends along the second direction Y, and the bit line structure 108 extends along the third direction Z, where one word line structure 109 surrounds a plurality of semiconductor layers 112 spaced apart along the second direction Y, and one bit line structure 108 is in contact with second surfaces f of a plurality of semiconductor layers 112 spaced apart along the third direction Z. In some other embodiments, the word line structure extends along the third direction, and the bit line structure extends along the second direction, where one word line structure covers at least one side surface of each of a plurality of semiconductor layers spaced apart along the third direction to form a single-sided gate, a double-sided gate, or an all-around gate, and one bit line structure is in contact with all second surfaces of a plurality of semiconductor layers spaced apart along the second direction. It should be noted that, FIG. 1 is a schematic structural diagram showing only one type of position relationship between the word line structure 109, the bit line structure 108, the semiconductor layer 112, and the capacitor 103.

It can be understood that, the word line structure 109 is configured for controlling the transistor 102, one word line structure 109 is provided with a plurality of parts respectively corresponding to a plurality of semiconductor layers 112, each part of the word line structure 109 surrounds one semiconductor layer 112, and the transistor 102 may further include a part of the word line structure 109 surrounding the semiconductor layer 112 in addition to the semiconductor layer 112. In other words, one transistor 102 includes only a partial region of the word line structure 109, and one word line structure 109 is coupled to semiconductor layers 112 of a plurality of transistors 102. In this way, a plurality of transistors 102 each include a part of the word line structure 109. In this case, one word line structure 109 can control a plurality of transistors 102 arranged along the second direction Y or the third direction Z, thereby helping to reduce complexity of controlling a plurality of components in the semiconductor structure while increasing the integration density of the transistor 102, the bit line structure 108, the word line structure 109, and the capacitor 103 in the semiconductor structure.

In some embodiments, a part of the semiconductor layer 112 in contact with the capacitor 103 includes a metal silicide. As a metal silicide is of a smaller resistivity than a semiconductor material that is not metalized, a resistivity of the semiconductor layer 112 including a metal silicide is smaller than that of a semiconductor layer 112 not including a metal silicide, thereby helping to reduce a resistance of the semiconductor layer 112. Further, the semiconductor layer 112 including the metal silicide being in contact with the capacitor 103 helps to reduce a contact resistance between the semiconductor layer 112 and the capacitor 103 and further improve electrical performance of the memory cell 111.

In some embodiments, the metal silicide includes at least one of cobalt silicide, nickel silicide, molybdenum silicide, titanium silicide, tungsten silicide, tantalum silicide, or platinum silicide.

In some embodiments, referring to FIG. 1, the word line structure 109 may include a gate dielectric layer 119 and a gate conductive layer 129. The gate dielectric layer 119 surrounds a part of a sidewall of the semiconductor layer 112 in length direction and extending along the first direction X, the gate conductive layer 129 surrounds a sidewall of the gate dielectric layer 119 away from the semiconductor layer 112 and extending along the first direction X, and the gate conductive layer 129 extends along the second direction Y. In this way, one gate conductive layer 129 is in contact with a plurality of gate dielectric layers 119 spaced apart along the second direction Y. It can be understood that, the semiconductor layer 112 surrounded by the gate dielectric layer 119 along the first direction X may function as a channel region of the transistor 102, and the gate conductive layer 129 is used for controlling on and off of the channel region.

In some embodiments, a material of the gate conductive layer 129 may be at least one of conductive materials such as titanium nitride, tungsten, or cobalt, and a material of the gate dielectric layer 119 may be at least one of insulating materials such as silicon oxide, silicon nitride, or silicon oxynitride.

In some embodiments, referring to FIGS. 2-5, FIG. 15, and FIG. 16, a plurality of memory cell groups 101 and a plurality of first conductive structures 104 are alternately arranged along the second direction Y; the first conductive structure 104 is located on a first side surface a of at least one memory cell group 101, where the memory cell group 101 is in contact with at least one first conductive structure 104. In this way, the first conductive structure 104 may be disposed at various positions relative to the memory cell group 101. In a case of ensuring that a structure for storing data in each memory cell 111 includes the capacitor 103 and a part of the first conductive structure 104 coupled to the memory cell 111, by adjusting a position relationship between the first conductive structure 104 and the memory cell group 101, an area of the first conductive structure 104 coupled to any one capacitor 103 is controlled, so that a capacitance of a capacitor structure for storing data in each memory cell 111 can be controlled.

It should be noted that, (a) in FIG. 3 and (b) in FIG. 3 are schematic diagrams showing two partial cross-sectional structures of the semiconductor structure shown in FIG. 1 along a third cross-sectional direction CC1; (a) in FIG. 4 and (b) in FIG. 4 are schematic diagrams showing another two partial cross-sectional structures of the semiconductor structure shown in FIG. 1 along the third cross-sectional direction CC1; (a) in FIG. 5 and (b) in FIG. 5 are schematic structural diagrams showing still another two partial cross-sectional structures of the semiconductor structure shown in FIG. 1 along the third cross-sectional direction CC1. In addition, for simplicity of illustration, a part of the semiconductor layer 112 in the transistor 102 is shown in FIG. 3 to FIG. 5 to illustrate an electrical connection relationship between the capacitor 103 and the transistor 102.

The position relationship between the first conductive structure 104 and the memory cell group 101 is explained in detail below.

In some embodiments, referring to FIG. 3 and (a) in FIG. 4, the first conductive structure 104 may be plate-shaped, and the first conductive structure 104 extends along the first direction X and the third direction Z. It can be understood that the first conductive structure 104 being plate-shaped means that a length of the first conductive structure 104 in the first direction X is much greater than a width of the first conductive structure 104 in the second direction Y. For example, a ratio of the length of the first conductive structure 104 in the first direction X to the width of the first conductive structure 104 in the second direction Y is greater than 2, so that the first conductive structure 104 is a plate-shaped structure perpendicular to the second direction Y.

Semiconductor structures corresponding to FIG. 3 and (a) in FIG. 4 are separately described in detail below.

In some examples, referring to (a) in FIG. 3, one first conductive structure 104 is coupled to capacitors 103 of two memory cell groups 101 (referring to FIG. 2) respectively on two sides of the first conductive structure 104, and only one first conductive structure 104 is disposed in an interval between two memory cell groups 101 adjacent to each other along the second direction Y. In other words, for one first conductive structure 104, two side surfaces of the first conductive structure opposite to each other in the second direction Y are respectively in contact with two first side surfaces a of two memory cell groups 101. That is, a same first conductive structure 104 is shared by two memory cell groups 101 coupled thereto. In this way, the structure for storing data in each memory cell 111 includes the capacitor 103 and two first conductive structures 104 coupled to the capacitor 103, thereby helping to further increase the capacitance of the capacitor structure for storing data corresponding to each memory cell 111, so that a data storage capability of the memory cell 111 is improved and thus the electrical performance of the memory cell group 101 is improved.

In some other examples, referring to (b) in FIG. 3, the first conductive structures 104 are in a one-to-one correspondence with the memory cell groups 101 (referring to FIG. 2). That is, any one first conductive structure 104 is coupled to only one first side surface a of one memory cell group 101. The other first side surface a of the memory cell group 101 is in contact with a second isolation layer 115. In addition, only one first conductive structure 104 is disposed in an interval between two memory cell groups 101 adjacent to each other along the second direction Y.

In still other examples, referring to (a) in FIG. 4, any one first conductive structure 104 is coupled to only one first side surface a of one memory cell group 101 (referring to FIG. 2), and for one memory cell group 101, two first side surfaces a of the memory cell group opposite to each other in the second direction Y are respectively coupled to two first conductive structures 104. In other words, two first conductive structures 104 are disposed in an interval between two memory cell groups 101 adjacent to each other along the second direction Y, and the two first conductive structures 104 are spaced apart along the second direction Y. This helps to further increase the capacitance of the capacitor structure for storing data corresponding to each memory cell 111 and reduce an arrangement area occupied by any one first conductive structure 104 in the semiconductor structure. Further, a width of any one first conductive structure 104 in the second direction Y is reduced on the premise of increasing the capacitance of the capacitor structure for storing data corresponding to each memory cell 111, thereby helping to reduce material costs of manufacturing the first conductive structures 104.

In some other embodiments, referring to (b) in FIG. 4, the first conductive structure 104 may be columnar. It can be understood that the first conductive structure 104 being columnar means that a difference between a length of the first conductive structure 104 in the first direction X and a width of the first conductive structure 104 in the second direction Y is not great, so that the first conductive structure 104 is a columnar structure perpendicular to the second direction Y. In other words, with a plane formed with the first direction X and the second direction Y as a reference plane, an orthographic projection shape or a cross-sectional shape of the first conductive structure 104 on the reference plane is a rectangle, and a length-width ratio of the rectangle is nearly 1. For example, the length-width ratio is 0.9 to 1.1.

It should be noted that, (b) in FIG. 4 shows an example in which any one first conductive structure 104 as a columnar structure is coupled to capacitors 103 of two memory cell groups 101 respectively on two sides of the first conductive structure 104 (referring to FIG. 2). In practical application, any one first conductive structure as a columnar structure may also subject to a position relationship between the first conductive structure 104 and the memory cell group 101 shown in FIG. 3b, that is, any one first conductive structure as a columnar structure is coupled to only one first side surface of one memory cell group, and the other first side surface of the memory cell group is in contact with the second isolation layer. Alternatively, any one first conductive structure as a columnar structure may be subject to a position relationship between the first conductive structure 104 and the memory cell group 101 shown in FIG. 4a, that is, any one first conductive structure as a columnar structure is coupled to only one first side surface of one memory cell group, and for one memory cell group, two first side surfaces of the memory cell group opposite to each other in the second direction are respectively coupled to two first conductive structures.

In addition, (b) in FIG. 4 shows an example in which two first conductive structures 104 as columnar structures are disposed in the interval between two memory cell groups 101 adjacent to each other along the second direction Y, and the two first conductive structures 104 are spaced apart along the first direction X. In practical application, for an interval between any two memory cell groups 101 adjacent to each other, the quantity of first conductive structures 104 spaced apart in the interval along the first direction X is not limited. For example, the quantity may be three, four, seven, or the like.

In still other embodiments, referring to FIG. 5, the first conductive structure 104 may be ring-shaped. It can be understood that, with a plane formed with the first direction X and the second direction Y as a reference plane, the first conductive structure 104 being ring-shaped means that an orthographic projection shape or a cross-sectional shape of the first conductive structure 104 on the reference plane is a ring.

In some embodiments, referring to FIG. 5, the capacitor 103 may include a first electrode 113, and the first electrode 113 extends along the first direction X. The semiconductor structure may further include a first dielectric layer 123 located between the first conductive structure 104 and the first electrode 113.

Semiconductor structures corresponding to (a) in FIG. 5 and (b) in FIG. 5 are separately described in detail below.

In some examples, referring to (a) in FIG. 5, the ring-shaped first conductive structure 104 includes an outer wall 104a and an inner wall 104b arranged opposite to each other and a bottom surface (not shown in FIG. 5) connecting the outer wall 104a and the inner wall 104b, and the first dielectric layer 123 covers the outer wall 104a, the inner wall 104b, and the bottom surface of the first conductive structure 104. In other words, the second isolation layer 115 is provided with a ring-shaped groove for accommodating the first conductive structure 104 and the first dielectric layer 123, the first dielectric layer 123 conformally covers an inner wall of the ring-shaped groove, and the first conductive structure 104 fills up a remaining part of the ring-shaped groove.

In some other examples, referring to (b) in FIG. 5, each ring-shaped first conductive structure 104 includes an outer wall 104a and an inner wall 104b arranged opposite to each other and a bottom surface (not shown in FIG. 5) connecting the outer wall 104a and the inner wall 104b, the first dielectric layer 123 covers the outer wall 104a and the bottom surface of the first conductive structure 104, and a groove formed by the inner wall 104b of the first conductive structure 104 is provided with a fourth isolation layer 135. In other words, the second isolation layer 115 is provided with a groove for accommodating the first conductive structure 104, the first dielectric layer 123, and the fourth isolation layer 135, an orthographic projection shape of the groove on the substrate 100 is a rectangle, the first dielectric layer 123 and the first conductive structure 104 sequentially conformally cover an inner wall of the groove, and the fourth isolation layer 135 fills up a remaining part of the groove.

In the foregoing embodiments, referring to (a) in FIG. 3, (b) in FIG. 4, and FIG. 5, at least one first conductive structure 104 is coupled to capacitors 103 of two memory cell groups 101 respectively on two sides of the first conductive structure 104. This helps to further increase the capacitance of the capacitor structure for storing data corresponding to each memory cell 111 (referring to FIG. 1), so that a data storage capability of the memory cell 111 is improved and thus the electrical performance of the memory cell group 101 (referring to FIG. 1) is improved.

In the foregoing embodiments, referring to FIG. 3 to FIG. 5, the capacitor 103 may include a first electrode 113, and the first electrode 113 extends along the first direction X. The semiconductor structure may further include a first dielectric layer 123 located between the first conductive structure 104 and the first electrode 113.

It can be understood that, in some examples, referring to FIG. 3 and FIG. 4, in a case that the first conductive structure 104 is a solid plate-shaped structure or columnar structure, the first dielectric layer 123 surrounds at least four sidewalls of the first conductive structure 104 extending along the third direction Z on the premise that the first dielectric layer 123 is located between the first conductive structure 104 and the first electrode 113. In some other examples, referring to FIG. 5, in a case that the first conductive structure 104 is a hollowed plate-shaped structure or columnar structure, that is, the first conductive structure 104 is ring-shaped, the first dielectric layer 123 surrounds at least the outer wall 104a of the first conductive structure 104 extending along the third direction Z on the premise that the first dielectric layer 123 is located between the first conductive structure 104 and the first electrode 113.

It should be noted that, the first dielectric layer 123 is used for achieving electrical insulation between the first electrode 113 and the first conductive structure 104. In this case, in an embodiment of the present disclosure, it is merely required that the first dielectric layer 123 is located between the first conductive structure 104 and the first electrode 113, and this embodiment of the present disclosure includes, but is not limited to, the embodiments showing a position relationship between the first dielectric layer 123, the first conductive structure 104, and the first electrode 113 shown in FIG. 3 to FIG. 5.

In addition, the capacitor 103 may include, in addition to the first electrode 113, the first dielectric layer 123 in contact with the first electrode 113, that is, one capacitor 103 includes one first electrode 113 and a part of the first dielectric layer 123, and the part of the first dielectric layer 123 is in contact with the first electrode 113.

It can be understood that, in the examples shown in FIG. 3 to FIG. 5, the first dielectric layer 123 extends along the third direction X like the first conductive structures 104 in contact with the first dielectric layer, that is, a same first dielectric layer 123 corresponds to a plurality of capacitors 103 arranged along the third direction Z, and each capacitor 103 includes only a part of the first dielectric layer 123.

It should be noted that, FIG. 3 to FIG. 5 show top views of the capacitor 103, and it can be understood that a top view of the memory cell group 101 (referring to FIG. 2) to which the capacitor 103 belongs overlaps a top view of the capacitor 103.

In some embodiments, referring to FIG. 6, FIG. 6 is a schematic diagram showing a partial cross-sectional structure of the first electrode 113 in the semiconductor structure shown in FIG. 3 to FIG. 5, and the first electrode 113 may be a cup-shaped structure with an opening 133 toward the first direction X. Referring to FIG. 3 to FIG. 6, the semiconductor structure may further include: first conductive parts 143 extending along the first direction X, where the first conductive parts 143 are in a one-to-one correspondence with the first electrodes 113, passing through the opening 133, and are respectively embedded in the first electrodes 113; a second dielectric layer 153 located between the first conductive parts 143 and the first electrodes 113; and a second conductive structure 163 located on a second side surface b of the memory cell group 101, where the second conductive structure and the memory cell group 101 are arranged along the first direction X, the second conductive structure 163 extends along the third direction Z, the second conductive structure 163 is electrically connected to the first conductive parts 143, and the second dielectric layer 153 is also located on a sidewall of the second conductive structure 163.

It can be understood that, the first electrode 113 itself forms a groove 183 with an opening 133, and a cross-sectional shape of the first electrode 113 along a cross-section perpendicular to the first direction X is a ring. The ring may be a circular ring, a square ring, or another polygonal ring.

In addition, on the premise that the first conductive structure 104 coupled to the capacitor 103 has been arranged, that is, the capacitance of the capacitor structure for storing data corresponding to each memory cell 111 has been ensured, the first electrode 113 may be designed to be a cup-shaped structure with an opening 133 toward the first direction X to further provide the first conductive part 143 and the second conductive structure 163 in a limited arrangement space. It can be understood that, the first conductive part 143 and the second conductive structure 163 as a whole can function as an upper electrode in the capacitor structure in the memory cell 111. This helps to further increase the capacitance of the capacitor structure for storing data corresponding to each memory cell 111 by adding the first conductive parts 143 and the second conductive structure 163, without reducing the integration density of the semiconductor structure.

In addition, as the first conductive structure 104 can function as the upper electrode of the capacitor structure in the memory cell 111, and the first conductive part 143 and the second conductive structure 163 as a whole can also function as the upper electrode of the capacitor structure in the memory cell 111, and therefore, in a case that the capacitance of the capacitor structure in the memory cell 111 is constant, a length of the first electrode 113 in the first direction X in the semiconductor structure provided according to an embodiment of the present disclosure may be reduced, thereby helping to reduce a length of the whole semiconductor structure in the first direction X and increase the integration density of the semiconductor structure. Further, the reduction of the length of the first electrode 113 in the first direction X helps to form the second dielectric layer 153 and the first conductive part 143 of more precise dimensions in the groove formed by the first electrode 113, thereby improving the electrical performance of the semiconductor structure.

In some embodiments, referring to FIG. 3 to FIG. 5, the second side surface b of the memory cell group 101 is perpendicular to the first direction X, and a same second side surface b includes side surfaces of a plurality of capacitors 103 arranged along the third direction Z. It can be understood that the second conductive structure 163 is located on a side of the capacitor 103 away from the semiconductor layer 112.

It should be noted that, the second dielectric layer 153 is used for achieving electrical insulation between the first electrode 113 and the first conductive part 143 and achieving electrical insulation between the first electrode 113 and the first conductive structure 163. In this case, in an embodiment of the present disclosure, it is merely required that the second dielectric layer 153 is located between the first conductive part 143 and the first electrode 113 and between the first conductive structure 163 and the first electrode 113, and this embodiment of the present disclosure includes, but is not limited to, the embodiments showing a position relationship between the second dielectric layer 153, the second conductive structure 163, and the first electrode 113 shown in FIG. 3 to FIG. 5.

Based on that the first electrode 113 may be a cup-shaped structure with an opening 133 toward the first direction X, the appearance of the first electrode 113 is described in detail below with reference to FIG. 6 and FIG. 7.

In some embodiments, referring to FIG. 6, an inner wall of the groove 183 with the opening 133 formed by the first electrode 113 itself is flat.

In some other embodiments, referring to (a) in FIG. 7, an inner wall of the groove 183 formed by the first electrode 113 is stepped, and the first electrode 113 can be regarded as a film layer conformally covering the inner wall of the groove 183. That is, the first electrode 113 itself is also stepped, and along the first direction X, a cross-sectional area of the groove 183 increases progressively in a direction perpendicular to the first direction X. In other embodiments, the first electrode 113 itself is stepped, and along the first direction X, a cross-sectional area of the groove 183 decreases progressively in a direction perpendicular to the first direction X.

In still other embodiments, referring to (b) in FIG. 7, the groove 183 formed by the first electrode 113 itself includes a first sub-groove 183a and a second sub-groove 183b alternately stacked along the first direction X. An area of an orthographic projection of the first sub-groove 183a on the substrate 100 is greater than an area of an orthographic projection of the second sub-groove 183b on the substrate 100. That is, an inner wall of the groove 183 defined by the first electrode 113 has an uneven appearance.

It can be understood that, (a) in FIG. 7 and (b) in FIG. 7 are schematic diagrams showing another two partial cross-sectional structures of a first electrode in a semiconductor structure provided according to an embodiment of the present disclosure. FIG. 7 shows two examples of an uneven surface of the first electrode 113. Referring to FIG. 7 and FIG. 5, based on that the first electrode 113 has an appearance shown in FIG. 7, the first dielectric layer 123 and the first conductive structure 104 sequentially conformally cover at least a part of an outer wall of the first electrode 113 extending along the first direction X. That is, a sidewall of the first conductive structure 104 facing the memory cell groups 101 is non-planar and has a stepped look or a sawtooth-like look in the first direction X. This helps to increase an area of directly facing part between the first electrode 113 and the first conductive structure 104. It can be understood that, the first electrode 113 may function as a lower electrode of the capacitor structure in the memory cell 111, and the first conductive structure 104 may function as the upper electrode of the capacitor structure in the memory cell 111, and this helps to further increase the capacitance of the capacitor structure for storing data corresponding to each memory cell 111 by increasing the area of a directly facing part of the first electrode 113 and the first conductive structure 104.

In addition, referring to FIG. 7 and FIG. 5, based on that the first electrode 113 has the appearance shown in FIG. 7, the second dielectric layer 153 conformally covers the inner wall of the groove 183 formed by the first electrode 113, and the first conductive part 143 fills up a remaining part of the groove 183. This helps to increase an area of directly facing part between the first electrode 113 and the first conductive part 143. It can be understood that, the first electrode 113 may function as a lower electrode of the capacitor structure in the memory cell 111, and the first conductive part 143 may also function as the upper electrode of the capacitor structure in the memory cell 111, and this helps to further increase the capacitance of the capacitor structure for storing data corresponding to each memory cell 111 by increasing the area of a directly facing part of the first electrode 113 and the first conductive part 143.

It should be noted that examples of an uneven surface of the first electrode 113 include, but are not limited to, two embodiments shown in FIG. 7. In addition, FIG. 6 and FIG. 7 are schematic diagrams showing cross-sectional structures of the first electrode 113 along the third cross-sectional direction CC1. In practical application, schematic diagrams showing cross-sectional structures of the first electrode 113 along the first cross-sectional direction AA1 may also be as shown in FIG. 6 and FIG. 7.

A corresponding relationship between the second conductive structure 163 and the first conductive part 143 is described in detail below with reference to FIG. 8. FIG. 8 is a schematic diagram showing three partial three-dimensional structures of a semiconductor structure provided according to an embodiment of the present disclosure.

In some embodiments, referring to (a) in FIG. 8, a plurality of second conductive structures 163 are spaced apart along the second direction Y, and each second conductive structure 163 is in contact with a plurality of first conductive parts 143 spaced apart along the third direction Z. It can be understood that, the second conductive structures 163 are in a one-to-one correspondence with the memory cell groups 101 (referring to FIG. 1). That is, part of the memory cells 111 (referring to FIG. 1) share a same second conductive structure 163.

It should be noted that the second conductive structure 163 and a plurality of first conductive parts 143 in contact with the second conductive structure may be an integrally formed structure. That is, the second conductive structure 163 and the plurality of first conductive parts 143 in contact with the second conductive structure may be formed through a same manufacturing process. In addition, to clearly illustrate the corresponding relationship between the second conductive structure 163 and the first conductive part 143, FIG. 8a illustrates the second conductive structure 163 and the first conductive part 143 in different filling manners.

In some other embodiments, referring to (b) in FIG. 8, the second conductive structure 163 is in contact with all first conductive parts 143. It can be understood that all the memory cell groups 101 (referring to FIG. 1) share one second conductive structure 163.

It should be noted that the second conductive structure 163 and all the first conductive parts 143 may be an integrally formed structure. That is, the second conductive structure 163 and all the first conductive parts 143 may be formed through a same manufacturing process. In addition, to clearly illustrate the corresponding relationship between the second conductive structure 163 and the first conductive part 143, FIG. 8b illustrates the second conductive structure 163 and the first conductive part 143 in different filling manners.

In still other embodiments, referring to (c) in FIG. 8, FIG. 11, and FIG. 12, the semiconductor structure may further include: second conductive parts 173, where the second conductive parts 173 extend along the second direction Y and are spaced apart along the third direction Z, the second conductive parts 173 each have a third side surface c and a fourth side surface d opposite to each other along the first direction X, the third side surface c is in contact with a plurality of first conductive parts 143 spaced apart along the second direction Y, and the fourth side surface d is in contact with the second conductive structure 163. It should be noted that in FIG. 8c, the second conductive structure 163 is drawn in perspective to clearly illustrate a corresponding relationship between the first conductive part 143, the second conductive part 173, and the second conductive structure 163.

It should be noted that the first conductive part 143, the second conductive part 173, and the second conductive structure 163 may be an integrally formed structure. That is, the first conductive part 143, the second conductive part 173, and the second conductive structure 163 may be formed through a same manufacturing process. In addition, to clearly illustrate the corresponding relationship between the first conductive part 143, the second conductive part 173, and the second conductive structure 163, (c) in FIG. 8 illustrates the first conductive part 143, the second conductive part 173, and the second conductive structure 163 in different filling manners.

In addition, for clarity of illustration, (a) to (c)) in FIG. 8 illustrate only a row of first conductive parts 143 spaced apart along the second direction Y. In an actual semiconductor structure, there are a plurality of rows of first conductive parts 143 shown in FIG. 8 along the third direction Z. The first conductive parts 143 spaced apart along the second direction Y and the third direction Z are not limited in the embodiments of the present disclosure and can be adjusted based on a practical requirement. In addition, the quantity of second conductive parts 173 spaced apart along the third direction Z is the same as the quantity of first conductive parts 143 spaced apart along the third direction Z in any one memory cell group 101.

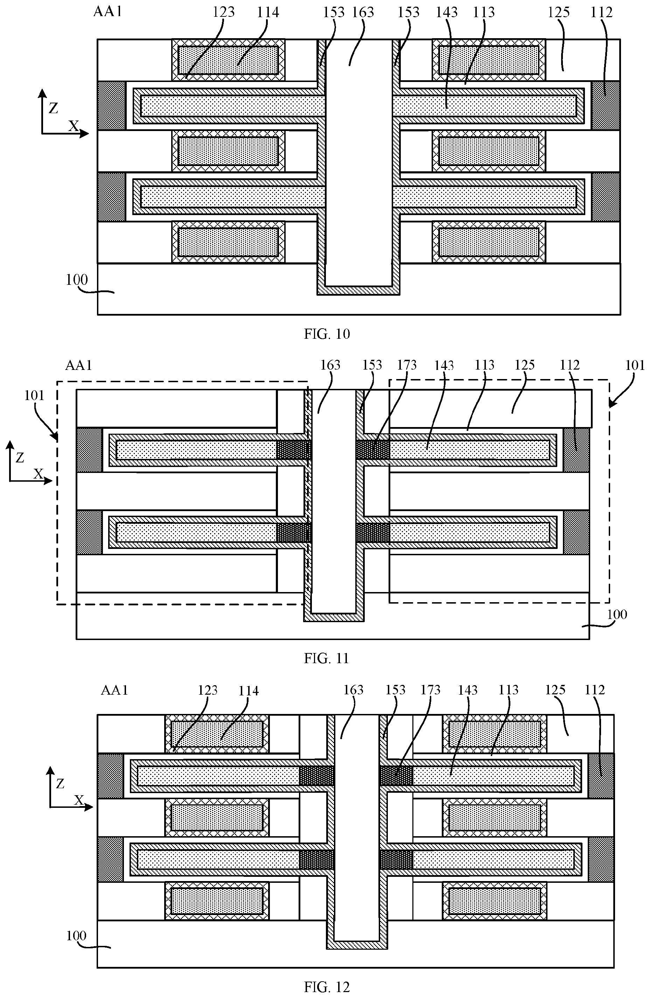

In some embodiments, referring to FIG. 11 or FIG. 12, the second dielectric layer 153 also covers a sidewall of the second conductive part 173. It can be understood that, the second dielectric layer 153 is further used for achieving electrical insulation between the first electrode 113 and the second conductive part 173. In this case, in an embodiment of the present disclosure, it is merely required that the second dielectric layer 153 is located between the second conductive part 173 and the first electrode 113, and this embodiment of the present disclosure includes, but is not limited to, the embodiments showing a position relationship between the second dielectric layer 153, the second conductive part 173, and the first electrode 113 shown in FIG. 11 and FIG. 12.

In some embodiments, referring to FIG. 9 and FIG. 10, the memory cell groups 101 may also be spaced apart along the first direction X, the first conductive parts 143 are also spaced apart along the first direction X, the first conductive parts 143 adjacent to each other along the first direction X are in contact with the same second conductive structure 163, and two adjacent memory cell groups 101 spaced apart along the first direction X are arranged in mirror symmetry along the second conductive structure 163.

It should be noted that, FIG. 9 to FIG. 12 are schematic diagrams showing another four partial cross-sectional structures of a semiconductor structure provided according to an embodiment of the present disclosure along a first cross-sectional direction AA1; FIG. 13 and FIG. 14 are schematic diagrams showing another two partial cross-sectional structures of a semiconductor structure provided according to an embodiment of the present disclosure along a second cross-sectional direction BB1.

It can be understood that, along the first direction X, the second conductive structure 163 has a fifth side surface g and a sixth side surface h opposite to each other. First conductive parts 143 corresponding to one memory cell group 101 in two adjacent memory cell groups 101 spaced apart along the first direction X are in contact with the fifth side surface g, and first conductive parts 143 corresponding to the other memory cell group 101 are in contact with the sixth side surface h. That is, the two adjacent memory cell groups 101 spaced apart along the first direction X share one second conductive structure 163, which helps to further increase the integration density of the semiconductor structure.

It should be noted that, the second conductive structure 163, the plurality of first conductive parts 143 in contact with the fifth side surface g, and the plurality of first conductive parts 143 in contact with the sixth side surface h may be an integrally formed structure, and FIG. 9 illustrates the first conductive parts 143 corresponding to the different memory cell groups 101 in a same filling manner. It can be understood that, as shown in FIG. 9 and FIG. 10, the second conductive structure 163, the plurality of first conductive parts 143 in contact with the fifth side surface g, and the plurality of first conductive parts 143 in contact with the sixth side surface h can be regarded as an upper electrode of the capacitor structure, and the upper electrode may correspond to a plurality of first electrodes 113. In addition, FIG. 9 illustrates an approximate scope of the memory cell groups 101 by using a dashed box.

It can be understood that, FIG. 9 and FIG. 10 may be schematic diagrams showing partial cross-sectional structures of the semiconductor structure shown in FIG. 8a along the first cross-sectional direction AA1, or may also be schematic diagrams showing partial cross-sectional structures of the semiconductor structure shown in FIG. 8b along the first cross-sectional direction AA1.

In some other embodiments, referring to FIG. 11 and FIG. 12, based on that the semiconductor structure further includes the second conductive parts 173, the memory cell groups 101 may also be spaced apart along the first direction X, the first conductive parts 143 are also spaced apart along the first direction X, and the second conductive parts 173 are also spaced apart along the first direction X; the second conductive parts 173 adjacent to each other along the first direction X are in contact with the same second conductive structure 163, two adjacent memory cell groups 101 spaced apart along the first direction X are arranged in mirror symmetry along the second conductive structure 163, and adjacent second conductive parts 173 spaced apart along the first direction X are also arranged in mirror symmetry along the second conductive structure 163.

In some embodiments, referring to FIG. 10, FIG. 12, and FIG. 13, the semiconductor structure may further include a conductive protrusion part 114 protruding from a sidewall of the first conductive structure 104 and sandwiched between first electrodes 113 adjacent to each other in the third direction Z; the first dielectric layer 123 is also located between the conductive protrusion part 114 and the first electrode 113.

In some embodiments, the conductive protrusion part 114 and the first conductive structure 104 may be an integrally formed structure. It should be noted that, the conductive protrusion part 114 in FIG. 10, FIG. 12, and FIG. 13 is illustrated in a same filling manner as the first conductive structure 104 in FIG. 13.

It can be understood that, referring to FIG. 13, except a row of first electrodes 113 arranged along the second direction Y and farthest away from the substrate 100, four sidewalls of each of other first electrodes 113 extending along the first direction X are surrounded by the conductive protrusion part 114 and the first conductive structure 104 together. In some embodiments, a top of the row of first electrodes 113 arranged along the second direction Y and farthest away from the substrate 100 is covered by the first isolation layer 105.

It should be noted that the conductive protrusion part 114 and the first conductive structure 104 are distinguished by using dashed lines in FIG. 13. It can be understood that, referring to FIG. 1 and FIG. 13, a plurality of first electrodes 113 spaced apart along the third direction Z all belong to one memory cell group 101, the conductive protrusion part 114 is located in an interval between two first electrodes 113 adjacent to each other along the third direction Z in any one memory cell group 101, and the first conductive structure 104 is located in an interval between two adjacent memory cell groups 101.

It can be understood that, the first electrode 113 may function as a lower electrode of the capacitor structure in the memory cell 111, and the conductive protrusion part 114 and the first conductive structure 104 as a whole may also function as the upper electrode of the capacitor structure in the memory cell 111, and this helps to increase the area of a directly facing part of the first electrode 113 and the upper electrode of the capacitor structure by adding the conductive protrusion part 114 and thereby further increase the capacitance of the capacitor structure for storing data corresponding to each memory cell 111.

In some embodiments, the first electrode 113 functions as the lower electrode of the capacitor structure in the memory cell 111, the conductive protrusion part 114 and the first conductive structure 104 as a whole function as a first upper electrode of the capacitor structure in the memory cell 111, and the first conductive part 143 and the second conductive structure 163 as a whole functions as a second upper electrode of the capacitor structure in the memory cell 111; or the first conductive part 143, the second conductive part 173, and the second conductive structure 163 as a whole functions as a second upper electrode of the capacitor structure in the memory cell 111. This helps to provide two upper electrodes for each memory cell 111 to further increase the capacitance of the capacitor structure for storing data corresponding to each memory cell 111.

In some other embodiments, referring to FIG. 9, FIG. 11, and FIG. 14, the semiconductor structure may not include the conductive protrusion part 114, and an interval between first electrodes 113 adjacent to each other along the third direction Z is filled with the second isolation layer 115.

In some embodiments, referring to FIG. 13 or FIG. 14, a second height H2 of the first conductive structure 104 along the third direction Z is greater than a first height H1 of the memory cell group 101 along the third direction Z; the semiconductor structure may further include a first isolation layer 105, where the first isolation layer 105 covers at least a top of the memory cell group 101, and the first conductive structure 104 is adjacent to the first isolation layer 105.

It can be understood that, the first isolation layer 105 may be used for achieving insulation between the first electrode 113 and other conductive structures in the semiconductor structure, and disposing the first conductive structure 104 at a layer to which the first isolation layer 105 belongs helps to subsequently control a potential of the first conductive structure 104.

It should be noted that, the foregoing embodiments all show an example in which the first electrode 113 is the cup-shaped structure with the opening 133 toward the first direction X and thus the semiconductor structure further includes the first conductive part 143 and the second conductive structure 163. Another form of the first electrode 113 is described in detail subsequently.

In some other embodiments, referring to FIG. 15 to FIG. 17, the first electrode 113 is a columnar structure extending along the first direction X, and the first dielectric layer 123 covers at least a part of a sidewall of the first electrode 113 parallel to the first direction X. It can be understood that the first electrode 113 shown in FIG. 15 to FIG. 17 is a solid structure. That is, the first electrode 113 itself does not form a groove.

It should be noted that, (a) in FIG. 15, (b) in FIG. 15, and (c) in FIG. 15 are schematic diagrams showing three partial cross-sectional structures of the semiconductor structure shown in FIG. 1 along a third cross-sectional direction CC1; (a) in FIG. 16, (b) in FIG. 16, and (c) in FIG. 16 are schematic diagrams showing another three partial cross-sectional structures of the semiconductor structure shown in FIG. 1 along the third cross-sectional direction CC1; (a) in FIG. 17 and (b) in FIG. 17 are schematic diagrams showing another two partial cross-sectional structures of a first electrode in a semiconductor structure provided according to an embodiment of the present disclosure. In addition, for simplicity of illustration, a part of the semiconductor layer 112 in the transistor 102 is shown in FIG. 15 and FIG. 16 to illustrate an electrical connection relationship between the capacitor 103 and the transistor 102.

It can be understood that, a cross-sectional shape of the first electrode 113 along a cross-section perpendicular to the first direction X may be a circle, a rectangle, or another polygonal shape. An example in which a cross-sectional shape of the first electrode 113 in a cross-section along the first direction X is a rectangle is described in detail below.

In some embodiments, referring to FIG. 15, the first dielectric layer 123 surrounds at least four sidewalls of the first electrode 113 extending along the first direction X. In some other embodiments, with further reference to FIG. 15, the first dielectric layer 123 may further cover a side of the first electrode 113 away from the semiconductor layer 112 in addition to surrounding the four sidewalls of the first electrode 113 extending along the first direction X.

In some other embodiments, referring to FIG. 16, the first dielectric layer 123 may surround four sidewalls of the first conductive structure 104 extending along the third direction Z.

It should be noted that, the first dielectric layer 123 is used for achieving electrical insulation between the first electrode 113 and the first conductive structure 104. In this case, in an embodiment of the present disclosure, it is merely required that the first dielectric layer 123 is located between the first conductive structure 104 and the first electrode 113, and this embodiment of the present disclosure includes, but is not limited to, the embodiments showing a position relationship between the first dielectric layer 123, the first conductive structure 104, and the first electrode 113 shown in FIG. 15 and FIG. 16.

A corresponding relationship between the first electrode 113, the first conductive structure 104, and the first dielectric layer 123 is described in detail below with reference to FIG. 15 and FIG. 16, and content that is the same as or that corresponds to the content of the foregoing embodiments is not described here again.

In some embodiments, referring to FIG. 15, any one first conductive structure 104 is coupled to capacitors 103 of two memory cell groups 101 (referring to FIG. 2) respectively on two sides of the first conductive structure 104.

In some examples, referring to (a) in FIG. 15, the first conductive structure 104 is plate-shaped, and only one first conductive structure 104 is disposed in an interval between two memory cell groups 101 adjacent to each other along the second direction Y. In other words, for one memory cell group 101, two first side surfaces a of the memory cell group opposite to each other in the second direction Y are respectively coupled to two first conductive structures 104. That is, a same first conductive structure 104 is shared by two memory cell groups 101 coupled to the first conductive structure.

In some other examples, referring to (b) in FIG. 15, an example is shown, in which the first conductive structure 104 may be columnar, and two first conductive structures 104 as columnar structures are disposed in the interval between two memory cell groups 101 adjacent to each other along the second direction Y and the two first conductive structures 104 are spaced apart along the first direction X.

In still other examples, referring to (c) in FIG. 15, the first conductive structure 104 may be ring-shaped, and only one first conductive structure 104 is disposed in an interval between two memory cell groups 101 adjacent to each other along the second direction Y.

In some other embodiments, referring to FIG. 16, the first conductive structures 104 are located on a first side surface a of at least one memory cell group 101 (referring to FIG. 2), where the memory cell group 101 is in contact with at least one first conductive structure 104.

In some examples, referring to (a) in FIG. 16, one first conductive structure 104 is coupled to capacitors 103 of two memory cell groups 101 (referring to FIG. 2) respectively on two sides of the first conductive structure 104.

In some other examples, referring to (b) in FIG. 16, the first conductive structures 104 are in a one-to-one correspondence with the memory cell groups 101 (referring to FIG. 2). That is, any one first conductive structure 104 is coupled to only one first side surface a of one memory cell group 101. The other first side surface a of the memory cell group 101 is in contact with a second isolation layer 115. In addition, only one first conductive structure 104 is disposed in an interval between two memory cell groups 101 adjacent to each other along the second direction Y.

In still other examples, referring to (c) in FIG. 16, any one first conductive structure 104 is coupled to only one first side surface a of one memory cell group 101 (referring to FIG. 2), and for one memory cell group 101, two first side surfaces a of the memory cell group opposite to each other in the second direction Y are respectively coupled to two first conductive structures 104.

It should be noted that, an example in which the first conductive structure 104 is plate-shaped is shown in FIG. 16. In practical application, the first conductive structure 104 shown in FIG. 16 may also be columnar or ring-shaped.

The appearance of the first electrode 113 is described in detail below with reference to FIG. 15 to FIG. 17, and content that is the same as or that corresponds to the content of the foregoing embodiments is not described here again.

In some embodiments, referring to FIG. 15 and FIG. 16, four sidewalls of the first electrode 113 extending along the first direction X are flat.

In some other embodiments, referring to (a) in FIG. 17, at least one of the four sidewalls of the first electrode 113 extending along the first direction X is stepped, and along the first direction X, a cross-sectional area of the first electrode 113 increases progressively in a direction perpendicular to the first direction X. It can be understood that, the first dielectric layer 123 can be regarded as a film layer conformally covering the sidewalls of the first electrode 113. That is, the first dielectric layer 123 is also stepped, so that the appearance of a sidewall of the first conductive structure 104 coupled to the first electrode 113 directly opposite to the first electrode 113 is also stepped.

In still other embodiments, referring to (b) in FIG. 17, the first electrode 113 includes a first sub-electrode 113a and a second sub-electrode 113b alternately stacked along the first direction X. An area of an orthographic projection of the first sub-electrode 113a on the substrate 100 is greater than an area of an orthographic projection of the second sub-electrode 113b on the substrate 100. That is, at least one of the four sidewalls of the first electrode 113 extending along the first direction X has an uneven appearance. It can be understood that, the first dielectric layer 123 can be regarded as a film layer conformally covering the sidewalls of the first electrode 113. That is, the first dielectric layer 123 is also uneven, so that the appearance of a sidewall of the first conductive structure 104 coupled to the first electrode 113 directly opposite to the first electrode 113 is also uneven.

It should be noted that, an example in which the four sidewalls of the first electrode 113 extending along the first direction X are flat is shown in FIG. 15 and FIG. 16. In practical application, the first electrode 113 in FIG. 15 and FIG. 16 may also be the same as the first electrode 113 shown in FIG. 17, and the appearance of the first dielectric layer 123 and the appearance of the sidewall of the first conductive structure 104 directly opposite to the first electrode 113 change as the appearance of the sidewalls of the first electrode 113 changes.

In some embodiments, referring to FIG. 13 and FIG. 14, a part of the first conductive structure 104 along the third direction Z is embedded in the substrate 100. In other words, the substrate 100 directly opposite to the first conductive structure 104 is provided with a trench, and the first dielectric layer 123 and the first conductive structure 104 also fill up the trench together. Referring to FIG. 13, this helps to ensure that all four sidewalls of each of a row of first electrodes 113 arranged along the second direction Y and closest to the substrate 100 are coupled to the first conductive structure 104, thus ensuring that a capacitance of a capacitor structure corresponding to each of the first electrodes 113 is relatively large.

In some embodiments, referring to FIG. 9 to FIG. 12, a part of the second conductive structure 163 along the third direction Z is embedded in the substrate 100. In other words, a bottom surface of the second conductive structure 163 is positioned lower than a top surface of the substrate 100. A trench is formed on a top of the substrate 100 directly opposite to the second conductive structure 163, and the second conductive structure 163 is accommodated in the trench.

In some embodiments, referring to FIG. 14, the semiconductor structure may further include a first electrical connection layer 106, where the first electrical connection layer 106 is electrically connected to a plurality of first conductive structures 104 spaced apart along the second direction Y, and the first electrical connection layer 106 is located above the plurality of first conductive structures 104.

It can be understood that, in FIG. 14, the conductive protrusion part 114 (referring to FIG. 13) is not disposed between first conductive structures 104 adjacent to each other along the second direction Y. In this case, potentials of the plurality of first conductive structures 104 in FIG. 14 are independent from each other. Based on this, disposing one first electrical connection layer 106 electrically connected to the plurality of first conductive structures 104 helps to achieve uniform control of the potentials of the plurality of first conductive structures 104 by using the first electrical connection layer 106.

It should be noted that, an example in which the first electrical connection layer 106 is in contact with a plurality of first conductive structures 104 is shown in FIG. 14. In practical application, any electrical connection structure that can achieve electrical connection between the first electrical connection layer 106 and a plurality of first conductive structures 104 spaced apart along the second direction Y can be regarded as the first electrical connection layer 106.

In some embodiments, referring to FIG. 3, along the first direction X, a first length L1 of the first conductive structure 104 is less than a second length L2 of the first electrode 113. It can be understood that, a ratio of the first length L1 to the second length L2 may be adjusted based on a requirement on the capacitance of the capacitor structure for storing data corresponding to each memory cell 111 (referring to FIG. 1).

In some embodiments, the ratio of the first length L1 to the second length L2 may range from 0.6 to 1.

It should be noted that the various first conductive structures 104 and the various first electrodes 113 shown in FIG. 3 to FIG. 5 and FIG. 15 and 16 all satisfy the condition that "the first length L1 is less than the second length L2". Referring to FIG. 4b or FIG. 15b, the first length L1 may be a total length of a plurality of first conductive structures 104 arranged along the first direction X. Referring to FIG. 5a, FIG. 5b, or FIG. 15c, the first length L1 may be a length of an outer contour of the first conductive structure 104 as a ring-shaped structure. Referring to FIG. 3 to FIG. 5 and FIG. 15 and FIG. 16, the second length L2 may be a length of an outer contour of the first electrode 113.

In some embodiments, referring to FIG. 3 to FIG. 5 and FIG. 15 and FIG. 16, the semiconductor structure may further include a second isolation layer 115, where the second isolation layer 115 is located on at least one side of the first conductive structure 104 along the first direction X, and the second isolation layer 115 is in contact with a sidewall of the first electrode 113. For example, the first conductive structure 104 and the second conductive structure 163 are spaced apart by the second isolation layer 115.

It should be noted that, the second isolation layer 115 is at least located between memory cell groups 101 adjacent to each other along the second direction Y, the first isolation layer 105 is located on a top of the memory cell groups 101, and a third isolation layer 125 is located between capacitors 103 adjacent to each other along the third direction Z in any one memory cell group 101. It can be understood that, an isolation layer in the semiconductor structure includes, but is not limited to, the first isolation layer 105, the second isolation layer 115, and the third isolation layer 125. The division of the isolation layers in this embodiment of the present disclosure is merely an example for showing a position relationship between the capacitor 103, the first conductive structure 104, the second conductive structure 163, and the like in the semiconductor structure.

In some embodiments, referring to FIG. 18, the semiconductor structure may further include a first conductive plug 107 located on the first conductive structure 104 and electrically connected to the first conductive structure 104; a second conductive plug 117 located on the second conductive structure 163 and electrically connected to the second conductive structure 163; and a second electrical connection layer 116 located on the first conductive plug 107 and the second conductive plug 117 and electrically connected to the first conductive plug 107 and the second conductive plug 117.

It should be noted that, FIG. 18 is a schematic diagram showing another partial cross-sectional structure of a semiconductor structure provided according to an embodiment of the present disclosure along a second cross-sectional direction BB1. In addition, in FIG. 18, to show the appearance of the first conductive structure 104 in a three-dimensional space, a same filling manner is applied to a top surface and a side surface perpendicular to the first direction X of the first conductive structure 104, and different filling manners are applied to the side surface perpendicular to the first direction X and a side surface perpendicular to the second direction Y of the first conductive structure 104. Similarly, in FIG. 18, different filling manners are applied to a side surface perpendicular to the first direction X and a side surface perpendicular to the second direction Y of the first conductive plug 107, a same filling manner is applied to a top surface and a side surface perpendicular to the first direction X of the second electrical connection layer 116, and different filling manners are applied to the side surface perpendicular to the first direction X and a side surface perpendicular to the second direction Y of the second electrical connection layer 116. In addition, in FIG. 18, the second conductive structure 163 is drawn in perspective.

It can be understood that, the first electrode 113 may function as a lower electrode of the capacitor structure in the memory cell 111, the first conductive structure 104 may function as an upper electrode of the capacitor structure in the memory cell 111, and the first conductive part 143 and the second conductive structure 163 as a whole may also function as an upper electrode of the capacitor structure in the memory cell 111. That is, one memory cell 111 may correspond to two upper electrodes, and electrical connection between the first conductive structure 104 and the second conductive structure 163 may be achieved by using the first conductive plug 107, the second conductive plug 117, and the second electrical connection layer 116. This helps to achieve uniform control of potentials of the two upper electrodes corresponding to the memory cell 111 by using the second electrical connection layer 116.

It should be noted that, the first conductive plug 107, the second conductive plug 117, and the second electrical connection layer 116 function to achieve the electrical connection between the first conductive structure 104 and the second conductive structure 163. To achieve the electrical connection between the first conductive structure 104 and the second conductive structure 163, the embodiments of the present disclosure include, but are not limited to, the example shown in FIG. 18. For example, referring to FIG. 14, the first conductive plug 107 may also be electrically connected to the first conductive structure 104 through the first electrical connection layer 106. In addition, to clearly illustrate the first conductive plug 107 and the second conductive plug 117, the second electrical connection layer 116 is drawn in perspective.

It can be understood that, other conductive structures may also be arranged at a film layer where the first conductive plug 107 and the second conductive plug 117 are located. The first conductive plug 107 and the second conductive plug 117 function to respectively lead out the first conductive structure 104 and the second conductive structure 163 onto the second electrical connection layer 116, thus avoiding overlapping of arrangement space of the second electrical connection layer 116 and the other conductive structures at the film layer where the first conductive plug 107 is located. That is, different conductive structures are disposed at film layers in different levels to achieve diversified wiring.

In summary, a part of the first conductive structure 104 may function as a conductive plate electrode of the capacitor 103, for example, an upper electrode of the capacitor 103, that is, the first conductive structure 104 and the plurality of capacitors 103 coupled thereto can form a capacitor structure. In this case, a structure for storing data in each memory cell 111 includes the capacitor 103 and part of the first conductive structure 104 coupled to the memory cell 111, thereby helping to increase a capacitance of the capacitor structure for storing data corresponding to each memory cell 111 by arranging the first conductive structure 104 and thereby increase a capacitance of the memory cell group 101. In addition, in one aspect, the first conductive structure 104 is arranged between the memory cell groups 101 adjacent to each other along the second direction Y, so that an added first conductive structure 104 does not increase a length of the semiconductor structure along the first direction X, and a space occupied by the first conductive structure 104 is a part of a space of an isolation layer originally arranged for isolating adjacent memory cell groups 101, thereby helping to reduce the length of the semiconductor structure in the first direction X and increase the integration density of the semiconductor structure; in another aspect, the first conductive structure 104 extends along the third direction Z, and it can be understood that the first conductive structure 104 may be manufactured along a direction perpendicular to the substrate 100, that is, a vertical direction, and the manufacturing process is simple, so that a precise dimension of the first conductive structure 104 can be easily controlled, thus improving electrical performance of the semiconductor structure.

Another embodiment of the present disclosure further provides a method for manufacturing a semiconductor structure, which is used to form the semiconductor structure provided according to the foregoing embodiments. The manufacturing method provided according to another embodiment of the present disclosure is described in detail below with reference to the drawings. FIG. 19 to FIG. 23 are schematic diagrams showing cross-sectional structures corresponding to steps in a method for manufacturing a semiconductor structure provided according to another embodiment of the present disclosure. It should be noted that, for convenience of description and clear illustration of the steps in the method for manufacturing the semiconductor structure, FIG. 19 to FIG. 23 in the embodiment are all schematic diagrams showing a partial structure of the semiconductor structure. Content that is the same as or that corresponds to the content of the foregoing embodiments is not described here again.

Referring to FIG. 1 to FIG. 23, the method for manufacturing the semiconductor structure includes: providing a substrate 100; forming a memory cell group 101 on the substrate 100, where the memory cell group 101 includes a plurality of vertically stacked memory cells 111, each one of the plurality of memory cells 111 includes a transistor 102 and a capacitor 103, and the capacitor 103 extends along a first direction X parallel to the substrate 100; and forming a first conductive structure 104, where the first conductive structure is located on a first side surface a of the memory cell group 101, the first conductive structure 104 and the memory cell group 101 are arranged along a second direction Y parallel to the substrate 100, the first conductive structure 104 extends along a third direction perpendicular to the substrate 100, the first conductive structure 104 is coupled to a plurality of capacitors 103 in the memory cell group 101, and the first direction X and the second direction Y intersect with each other.

It can be understood that, the first conductive structure 104 may function as a conductive plate electrode of any one capacitor 103, and the first conductive structure 104 and the plurality of capacitors 103 coupled thereto can form a capacitor structure. In this case, a structure for storing data in each memory cell 111 includes the capacitor 103 and a part of the first conductive structure 104 coupled to the memory cell 111. Based on this, the first conductive structure 104 is formed between memory cell groups 101 spaced apart along the second direction Y. In one aspect, the first conductive structure 104 may be formed by vertical etching and vertical filling, and a process for forming the first conductive structure 104 is simple, thereby helping to improve dimension precision of the formed first conductive structure 104; in another aspect, as the first conductive structure 104 is added, a length of the capacitor 103 in the first direction X can be reduced, which, when a through hole is formed by etching and the capacitor 103 is formed in the through hole, helps to reduce an aspect ratio of the through hole, reduce difficulty in etching, and further reduce difficulty of filling the capacitor 103 when the capacitor 103 is formed in the through hole, thereby helping to simplify steps in a process for manufacturing the capacitor 103 and improving dimension precision of the formed capacitor 103.

In addition, the first conductive structure 104 is disposed at least in an isolation layer for isolating adjacent memory cell groups 101. That is, the first conductive structure 104 occupies a space that is a part of a space of the isolation layer for isolating adjacent memory cell groups 101, thereby helping to reduce a length of the semiconductor structure in the first direction X while a capacitance of a capacitor structure corresponding to any one memory cell group 101 is increased and thereby increasing integration density of the semiconductor structure.

Therefore, the manufacturing method provided according to another embodiment of the present disclosure can not only increase the capacitance of the capacitor structure corresponding to any one memory cell group 101 without additionally providing arrangement space, but can also help to simplify the steps in the processes for forming the capacitor 103 and the first conductive structure 104 and improve the dimension precision of the formed capacitor 103 and the first conductive structure 104, thereby improving electrical performance of the semiconductor structure while improving the integration density of the semiconductor structure.

It should be noted that, the transistor 102, the bit line structure 108, and the word line structure 109 may all have been formed in the semiconductor structure before the capacitor 103 and the first conductive structure 104 are formed; or the transistor 102, the bit line structure 108, and the word line structure 109 are formed in the semiconductor structure after the capacitor 103 and the first conductive structure 104 are formed.

An example in which the transistor 102, the bit line structure 108, and the word line structure 109 may all have been formed in the semiconductor structure is used subsequently to describe how to form the capacitor 103 and the first conductive structure 104 in another embodiment of the present disclosure in detail with reference to FIG. 1 to FIG. 23.

In some embodiments, forming the memory cell groups 101 on the substrate 100 includes the following step:
referring to FIG. 1 to FIG. 21, forming a plurality of first electrodes 113 extending along the first direction X on the substrate 100, where the plurality of first electrodes 113 are spaced apart along the second direction Y and the third direction Z, and the first direction X and the second direction Y intersect with each other and are both parallel to the substrate 100.

In some embodiments, the step of forming the plurality of first electrodes 113 extending along the first direction X on the substrate 100 includes:
referring to FIG. 19, forming a stack structure 110 on the substrate 100, where the stack structure 110 includes a first sacrificial layer 120 and a second sacrificial layer 130 alternately stacked along the third direction Z. It can be understood that materials of the first sacrificial layer 120 and the second sacrificial layer 130 are different. FIG. 19 shows merely an example of the first sacrificial layer 120 and the second sacrificial layer 130 alternately stacked in the stack structure 110. In practical application, the quantity of the first sacrificial layers 120 and the quantity of the second sacrificial layers 130 in the stack structure 110 are not limited.

In some embodiments, the stack structure 110 may be formed through epitaxial growth. For example, the first sacrificial layer 120 and the second sacrificial layer 130 are respectively silicon germanium and silicon. In some other embodiments, the stack structure 110 may be formed through chemical vapor deposition. For example, the first sacrificial layer 120 and the second sacrificial layer 130 are respectively an insulating layer and a semiconductor layer, where the semiconductor layer may be a polycrystalline silicon or metal oxide semiconductor layer, and the metal oxide semiconductor layer includes, but is not limited to, one or more of zinc tin oxide (ZnₓSn_{y}O, commonly known as "ZTO"), indium zinc oxide (InₓZn_{y}O, commonly known as "IZO"), zinc oxide (ZnₓO), indium gallium zinc oxide (InₓGa_{y}Zn_{z}O, commonly known as "IGZO"), indium gallium silicon oxide (InₓGa_{y}Si_{z}O, commonly known as "IGSO"), indium tungsten oxide (InₓW_{y}O, commonly known as "IWO"), indium oxide (InₓO), and the like.

FIG. 19 is a schematic diagram showing a cross-sectional structure taken along a first cross-sectional direction AA1 when the stack structure 110 is formed in the method for manufacturing the semiconductor structure provided according to another embodiment of the present disclosure.

It can be understood that, after the stack structure 110 is formed and before capacitor grooves 131 are formed, the manufacturing method may further include forming the transistor 102, the bit line structure 108, and the word line structure 109. It should be noted that, a position relationship between the transistor 102, the bit line structure 108, and the word line structure 109 and the subsequently formed capacitor 103 has been described in detail in the foregoing embodiments and is not described in detail here again.

Referring to FIG. 19 to FIG. 21, the second sacrificial layer 130 is patterned to form capacitor grooves 131 extending along the first direction X, and a plurality of capacitor grooves 131 are spaced apart at least along the second direction Y; referring to FIG. 21 and FIG. 3 to FIG. 8 or referring to FIG. 21 and FIG. 15 to FIG. 17, the first electrodes 113 are respectively formed in the capacitor grooves 131.

In some embodiments, patterning the second sacrificial layer 130 includes the following step:
referring to FIG. 19 and FIG. 20, etching the stack structure 110 to form a second through hole 149 penetrating through the stack structure 110 in the third direction Z, where the second through hole 149 exposes the first sacrificial layer 120 and the second sacrificial layer 130. It can be understood that, the second through hole 149 is mainly used to define a position of the second conductive structure 163 (referring to FIG. 9), and the second dielectric layer 153 (referring to FIG. 9) and the second conductive structure 163 are subsequently formed in the second through hole 149.

FIG. 20 is a schematic diagram showing a cross-sectional structure taken along a first cross-sectional direction AA1 when the second through hole 149 is formed in the method for manufacturing the semiconductor structure provided according to another embodiment of the present disclosure.

In some examples, referring to (a) in FIG. 8 and FIG. 20, in the step of etching the stack structure 110 to form the second through hole 149, there may be a plurality of formed second through holes 149, and the plurality of second through holes 149 are spaced apart along the second direction Y. In some other examples, referring to (b) in FIG. 8 and FIG. 20, or referring to (c) in FIG. 8 and FIG. 20, in the step of etching the stack structure 110 to form the second through hole 149, there may be one formed second through hole 149, which helps to further simplify steps in a process.

In some embodiments, referring to (b) in FIG. 8 or (c) in FIG. 8, the second conductive structure 163 is electrically connected to all the first conductive parts 143. referring to FIG. 1, FIG. 8, and FIG. 20, a plurality of memory cell groups 101 are arranged along the second direction Y, and the formed second through hole 149 may expose only a first sacrificial layer 120 and a second sacrificial layer 130 corresponding to one memory cell group 101. In other words, a dimension of an opening of the second through hole 149 may be relatively small, and the second through hole 149 does not need to expose a first sacrificial layer 120 and a second sacrificial layer 130 corresponding to each memory cell group 101. Subsequently, the stack structure is wet-etched based on the second through hole 149 to form a capacitor groove at a position at which a part of the second sacrificial layer corresponding to any one memory cell group 101 is located. This helps to improve the steps in the process for forming the second through hole 149 and shorten time for forming the second through hole 149.

In some embodiments, referring to FIG. 20, in the step of etching the stack structure 110 to form the second through hole 149, the substrate 100 is also etched. That is, the second through hole 149 also penetrates a part of the substrate 100 in thickness, so that the subsequently formed second conductive structure is embedded in the substrate 100.

Referring to FIG. 20 and FIG. 21, lateral etching is performed along the second through hole 149 to remove a part of the second sacrificial layer 130 and form the capacitor groove 131.

FIG. 21 is a schematic diagram showing a cross-sectional structure taken along a first cross-sectional direction AA1 when the capacitor groove 131 is formed in the method for manufacturing the semiconductor structure provided according to another embodiment of the present disclosure.

In some embodiments, a cross-sectional shape of the second through hole 149 along a cross-section perpendicular to the first direction X may be a square, a circular ring, or another polygonal shape. An example in which a cross-sectional shape of the second through hole 149 in a cross-section along the first direction X is a square is subsequently described.

In some embodiments, the second sacrificial layer 130 includes a first sub-sacrificial layer and a second sub-sacrificial layer alternately arranged along the second direction Y, where the semiconductor layer 112 is in contact with the first sub-sacrificial layer, the semiconductor layer 112 is in a one-to-one correspondence with the first sub-sacrificial layer, and a part of the second sub-sacrificial layer subsequently functions as a second isolation layer 115 (referring to FIG. 3). Based on this, the step of performing lateral etching along the second through hole 149 to remove the part of the second sacrificial layer 130 includes: performing lateral etching along the second through hole 149 to remove the first sub-sacrificial layer and thereby form a capacitor groove 131 exposing the semiconductor layer 112.

It can be understood that, in some examples, the capacitor groove 131 may be subsequently used to form the first electrode 113 shown in FIG. 15 to FIG. 17. That is, the first electrode 113 itself is a solid structure. It should be noted that, to form the first electrode 113 shown in FIG. 17, the capacitor groove formed by performing lateral etching along the second through hole 149 to remove the first sub-sacrificial layer is an initial capacitor groove, and the initial capacitor groove is processed through an etching process to form a capacitor groove with an inner wall looking stepped or uneven. A specific process for forming the capacitor groove with the stepped or uneven inner wall is not limited in another embodiment of the present disclosure.

In some other examples, the capacitor groove 131 may subsequently be used to form the first electrode 113 shown in FIG. 3 to FIG. 7, and may further be used to form the second dielectric layer 153 and the first conductive part 143 shown in FIG. 3 to FIG. 5, and the like. It should be noted that, to form the first electrode 113 shown in FIG. 7, the capacitor groove formed by performing lateral etching along the second through hole 149 to remove the first sub-sacrificial layer is an initial capacitor groove, and the initial capacitor groove is processed through an etching process to form a capacitor groove with an inner wall looking stepped or unevenly sawtooth-like. A specific process for forming the capacitor groove with the inner wall looking stepped or unevenly sawtooth-like is not limited in another embodiment of the present disclosure.

It can be understood that, the formed capacitor grooves 131 are arranged into an array along the second direction Y and the third direction Z, and a plurality of capacitor grooves 131 spaced apart along the third direction Z are subsequently used to form a part of the memory cell group 101 (referring to FIG. 1).

In some embodiments, referring to FIG. 21 and FIG. 9, the step of forming the first electrodes 113 respectively in the capacitor grooves 131 includes: forming the first electrodes 113 conformally covering inner walls of the capacitor grooves 131, respectively, where the first electrode 113 is a cup-shaped structure with an opening 133 toward the first direction X; the manufacturing method may further include: forming a second dielectric layer 153 at least conformally covering an inner wall of the first electrode 113, and forming first conductive parts 143 and a second conductive structure 163 on a surface of the second dielectric layer 153, where the first conductive parts 143 are in a one-to-one correspondence with the first electrodes 113, pass through the opening 133, and are respectively embedded in the first electrodes 113, and the second conductive structure 163 fills up the second through hole 149.

It can be understood that, referring to FIG. 21, the plurality of capacitor grooves 131 are in communication with the second through hole 149 to form a first void, and the step of forming the first electrodes 113 includes: conformally covering an inner wall of the first void with a first electrode film, and etching a part of the first electrode film through the second through hole 149 to form the first electrodes 113 in a one-to-one correspondence with the capacitor grooves 131, that is, the first electrodes 113 are arranged into an array along the second direction Y and the third direction Z; and conformally covering a remaining part of the first void with one second dielectric layer 153, and finally filling up the first void with a conductive material. A conductive material filled into the capacitor grooves 131 transversely, that is, along the first direction X, functions as the first conductive parts 143, and a conductive material filled into the second through hole 149 vertically, that is, along the third direction Z, functions as the second conductive structure 163, so that the first conductive parts 143 and the second conductive structure 163 are integrally formed.

In addition, referring to FIG. 3, the subsequently formed first conductive structure 104 can increase the capacitance of the capacitor structure for storing data corresponding to each memory cell 111, and as the first conductive structure 104 is disposed between memory cell groups 101 adjacent to each other along the second direction Y, the added first conductive structure 104 does not increase a length of the semiconductor structure along the first direction X.

Based on this, referring to FIG. 21, a capacitor groove 131 with a smaller depth in the first direction X may be manufactured, that is, an aspect ratio of the capacitor groove 131 may be reduced according to another embodiment of the present disclosure. In this way, when the first electrode 113 conformally covers an inner wall of the capacitor groove 131 subsequently, a problem that the first electrode 113 cannot adequately fill the groove due to a too large aspect ratio of the capacitor groove 131 can be avoided, thereby helping to improve dimension precision of the formed first electrode 113, and similarly, a problem that the second dielectric layer 153 and the first conductive part 143 cannot adequately fill the capacitor groove 131 can be avoided, thereby helping to improve dimension precision of the formed second dielectric layer 153 and the formed first conductive part 143.

In some other embodiments, after the lateral etching is performed along the second through hole 149 to remove the first sub-sacrificial layer to form the capacitor groove 131 exposing the semiconductor layer 112, referring to FIG. 21 and FIG. 11, after forming the first electrodes 113 respectively in the capacitor grooves 131 and before forming the second dielectric layer 153, the manufacturing method may further include: performing lateral etching along the second through hole 149 to remove a part of the second sub-sacrificial layer and a part of the first electrode 113 to form a trench extending along the second direction Y, where a plurality of trenches are spaced apart along the third direction Z, and one trench exposes a plurality of capacitor grooves 131 arranged along the second direction Y.

It can be understood that, the plurality of capacitor grooves 131 and the plurality of trenches are all in communication with the second through hole 149 to form a second void, an inner wall of the second void is conformally covered with one second dielectric layer 153, and finally the second void is filled with a conductive material. A conductive material filled into the capacitor groove 131 transversely, that is, along the first direction X, functions as the first conductive parts 143, a conductive material filled into the trenches along the first direction X functions as the second conductive parts 173, and a conductive material filled into the second through hole 149 vertically, that is, along the third direction Z, functions as the second conductive structure 163, so that the first conductive parts 143, the second conductive parts 173, and the second conductive structure 163 are integrally formed.

In some embodiments, after forming the first electrodes 113, forming the memory cell groups 101 on the substrate 100 further includes the following step: referring to FIG. 3 to FIG. 17, forming a first dielectric layer 123, where the first dielectric layer 123 is located on a sidewall of the first electrode 113, and after the first conductive structure 104 is formed, the first conductive structure 104 comes in contact with the first dielectric layer 123.

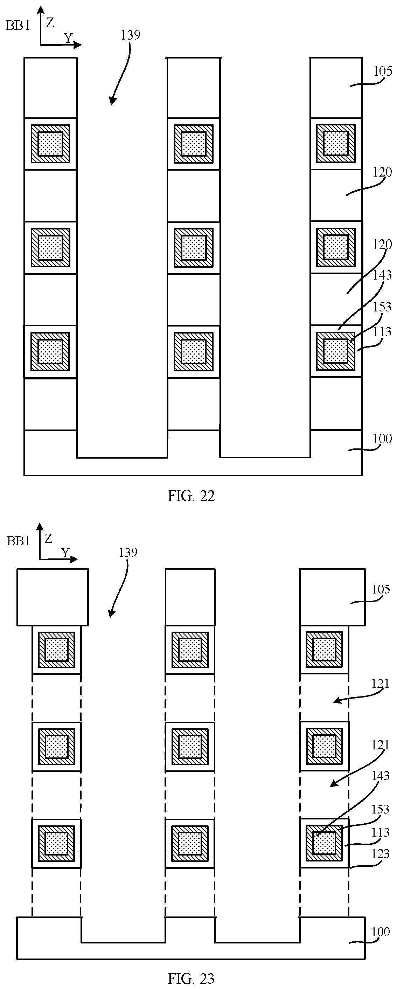

In some embodiments, the step of forming the first conductive structure 104 includes: referring to FIG. 22, etching the stack structure 110 (referring to FIG. 19) to form a first through hole 139 penetrating through the stack structure 110 in the third direction Z, where the first through hole 139 is located between first electrodes 113 adjacent to each other along the second direction Y; and referring to FIG. 22 and FIG. 14, forming the first conductive structure 104 in the first through hole 139.

FIG. 22 is a schematic diagram showing a cross-sectional structure taken along a first cross-sectional direction AA1 when the first through hole 139 is formed in the method for manufacturing the semiconductor structure provided according to another embodiment of the present disclosure.

In some embodiments, referring to FIG. 14, in the step of etching the stack structure 110 to form the first through hole 139, the substrate 100 is also etched. That is, the first through hole 139 also penetrates a part of the substrate 100 in thickness, so that the subsequently formed first conductive structure is embedded in the substrate 100.

In some embodiments, referring to FIG. 22 and FIG. 14, top surfaces of a row of first electrodes 113 arranged along the second direction Y and farthest away from the substrate 100 are further provided with one first isolation layer 105. In the step of etching the stack structure 110 to form the first through hole 139, the first isolation layer 105 is also etched. That is, the first through hole 139 also penetrates through the first isolation layer 105, so that a second height of the subsequently formed first conductive structure along the third direction is greater than a first height of the memory cell group along the third direction.

In some embodiments, based on that the first electrode 113 is a cup-shaped structure with an opening 133 as shown in FIG. 3 to FIG. 5, the first dielectric layer 123 conformally covering an inner wall of the first through hole 139 is formed before the first conductive structure 104 is formed in the first through hole 139, and then the first conductive structure 104 filling up a remaining part of the first through hole 139 is formed.

In some other embodiments, based on that the first electrode 113 is a columnar structure as shown in FIG. 15, the first dielectric layer 123 may be formed right after the first electrode 113 is formed, and only the first conductive structure 104 needs to be formed in the first through hole 139.

In still other embodiments, based on that the first electrode 113 is a columnar structure as shown in FIG. 16, the first dielectric layer 123 conformally covering an inner wall of the first through hole 139 may be formed still before the first conductive structure 104 is formed in the first through hole 139, and then the first conductive structure 104 filling up a remaining part of the first through hole 139 is formed.

It can be understood that, a time point for forming the first dielectric layer 123 can be flexibly adjusted based on the appearance of the formed first electrode 113. In addition, referring to FIG. 22 and FIG. 14, a remaining part of the first sacrificial layer 120 may function as a third isolation layer 125.

In some embodiments, referring to FIG. 22, a plurality of first through holes 139 are spaced apart at least along the second direction Y; referring to FIG. 14, after the first conductive structures 104 are respectively formed in the first through holes 139, the manufacturing method may further include: forming a first electrical connection layer 106 on top surfaces of a plurality of first conductive structures 104, where the first electrical connection layer 106 is electrically connected to the plurality of first conductive structures 104 spaced apart along the second direction Y.

In some other embodiments, referring to FIG. 22, the first through hole 139 exposes a sidewall of the first electrode 113 and a sidewall of the first sacrificial layer 120, and the manufacturing method may further include the following step:
referring to FIG. 22 and FIG. 23, performing lateral etching along the first through hole 139 to remove the first sacrificial layer 120 exposed by the first through hole 139 and form an intercommunication groove 121, where the intercommunication groove 121 is located between first electrodes 113 adjacent to each other along the third direction Z, and the intercommunication groove 121 is in communication with two first through holes 139 adjacent to each other along the second direction Y.

Referring to FIG. 23 and FIG. 13, the formed first dielectric layer 123 also covers an inner wall of the intercommunication groove 121.

Referring to FIG. 23 and FIG. 13, the step of forming the first conductive structure 104 in the first through hole 139 further includes: forming a conductive protrusion part 114 in the intercommunication groove 121.

FIG. 23 is a schematic diagram showing a cross-sectional structure taken along a first cross-sectional direction AA1 when the intercommunication groove 121 is formed in the method for manufacturing the semiconductor structure provided according to another embodiment of the present disclosure.

It can be understood that, referring to FIG. 1 and FIG. 23, a plurality of memory cell groups 101 are arranged along the second direction Y, and the first through hole 139 may be formed in an interval between only some adjacent memory cell groups 101. FIG. 23 shows an example in which two first through holes 139 are formed, but in practical application, only one first through hole 139 may be formed. In other words, a dimension of an opening of the first through hole 139 may be relatively small, and the first through hole 139 does not need to expose a first electrode 113 and a first sacrificial layer 120 corresponding to each memory cell group 101. Subsequently, the stack structure is wet-etched based on the first through hole 139 to form the intercommunication groove 121 at a position at which the first sacrificial layer 120 corresponding to any one memory cell group 101 is located. This helps to improve the steps in the process for forming the first through hole 139 and shorten time for forming the first through hole 139.

In addition, referring to FIG. 3 to FIG. 5 or FIG. 15 and FIG. 16, the first conductive structure 104 surrounds only a part of the first electrode 113 in length along the first direction X. Therefore, in the step of wet-etching the stack structure based on the first through hole 139, a remaining part of the first sacrificial layer 120 is also connected to a sidewall of the first electrode 113 extending along the first direction X. It can be understood that the part of the first sacrificial layer 120 may function as a support layer to prevent the manufactured first electrode 113 from collapsing, thereby helping to improve a yield of finally formed semiconductor structures.

In some embodiments, the first electrode 113 is a cup-shaped structure as shown in FIG. 3 to FIG. 7. Based on this, before the first through hole 139 is formed, the first electrode 113 is also nested with the second dielectric layer 153 and the first conductive part 143, and the first conductive part 143 is in contact with the second conductive structure 163, so that the second dielectric layer 153, the first conductive part 143, and the second conductive structure 163 together can support the first electrode 113 to prevent the manufactured first electrode 113 from collapsing in the step of wet-etching the stack structure based on the first through hole 139, thereby helping to improve a yield of finally formed semiconductor structures.

Those of ordinary skill in the art can understand that the foregoing implementations are specific embodiments of practicing the present disclosure, while in practical application, various changes can be made to the implementations in form and detail without departing from the spirit and scope of the embodiments of the present disclosure. Any person skilled in the art can make various changes and modifications without departing from the spirit and scope of the embodiments of the present disclosure, and the protection scope of the embodiments of the present disclosure is defined by the appended claims.

## Claims

1. A semiconductor structure, comprising:
a substrate (100);
a memory cell group (101) on the substrate, wherein the memory cell group comprises a plurality of vertically stacked memory cells (111), each one of the plurality of memory cells comprises a transistor (102) and a capacitor (103), and the capacitor extends along a first direction (X) parallel to the substrate; and
a first conductive structure **(104)** located on a first side surface (a) of the memory cell group, wherein the first conductive structure and the memory cell group are arranged along a second direction (Y) parallel to the substrate, the first conductive structure extends along a third direction (Z) perpendicular to the substrate, the first conductive structure is coupled to a plurality of capacitors in the memory cell group, and the first direction and the second direction intersect with each other.

2. The semiconductor structure according to claim 1, wherein a plurality of memory cell groups and a plurality of first conductive structures are alternately arranged along the second direction; each one of the plurality of first conductive structures is located on a first side surface of at least one of the plurality of memory cell groups, and each one of the plurality of memory cell groups is in contact with at least one of the plurality of first conductive structures.

3. The semiconductor structure according to claim 1, wherein the first conductive structure is plate-shaped, and the first conductive structure extends along the first direction and the third direction.

4. The semiconductor structure according to claim 2, wherein at least one of the first conductive structures is coupled to capacitors in two of the plurality of memory cell groups respectively on two sides of the first conductive structure.

5. The semiconductor structure according to any one of claims 1 to 4, wherein a second height (H2) of the first conductive structure along the third direction is greater than a first height (H1) of the memory cell group along the third direction; the semiconductor structure further comprises a first isolation layer (105), wherein the first isolation layer covers at least a top of the memory cell group, and the first conductive structure is adjacent to the first isolation layer.

6. The semiconductor structure according to any one of claims 1 to 4, wherein the capacitor comprises a first electrode (113), and the first electrode extends along the first direction; the semiconductor structure further comprises a first dielectric layer (123) located between the first conductive structure and the first electrode.

7. The semiconductor structure according to claim 6, further comprising: a conductive protrusion part (114) protruding from a sidewall of the first conductive structure and sandwiched between first electrodes adjacent to each other along the third direction, wherein
the first dielectric layer is also located between the conductive protrusion part and the first electrode.

8. The semiconductor structure according to claim 6, wherein the first electrode is a cup-shaped structure with an opening toward the first direction, and the semiconductor structure further comprises:
first conductive parts extending along the first direction, wherein the first conductive parts are in a one-to-one correspondence with the first electrodes, pass through the opening, and are respectively embedded in the first electrodes;
a second dielectric layer (153) located between the first conductive parts and the first electrodes; and
a second conductive structure (163) located on a second side surface (b) of the memory cell group, wherein the second conductive structure and the memory cell group are arranged along the first direction, the second conductive structure extends along the third direction, the second conductive structure is electrically connected to the first conductive parts, and the second dielectric layer also covers a sidewall of the second conductive structure.

9. The semiconductor structure according to claim 8, wherein the second conductive structure is in contact with all the first conductive parts; or a plurality of second conductive structures are spaced apart along the second direction, and each one of the plurality of second conductive structures is in contact with a plurality of first conductive parts spaced apart along the third direction.

10. The semiconductor structure according to claim 8, further comprising: second conductive parts (173), wherein the second conductive parts extend along the second direction and are spaced apart along the third direction, the second conductive parts each have a third side surface (c) and a fourth side surface (d) opposite to each other along the first direction, the third side surface is in contact with a plurality of first conductive parts spaced apart along the second direction, and the fourth side surface is in contact with the second conductive structure; the second dielectric layer also covers a sidewall of the second conductive part.

11. The semiconductor structure according to claim 8, wherein the plurality of memory cell groups are also spaced apart along the first direction, the first conductive parts are also spaced apart along the first direction, the first conductive parts adjacent to each other along the first direction are in contact with a same second conductive structure, and two adjacent memory cell groups spaced apart along the first direction are arranged in mirror symmetry along the second conductive structure.

12. The semiconductor structure according to claim 6, wherein the first electrode is a columnar structure extending along the first direction, and the first dielectric layer covers at least a part of a sidewall of the first electrode parallel to the first direction.

13. The semiconductor structure according to any one of claims 1 to 4, wherein a part of the first conductive structure along the third direction is embedded in the substrate.

14. The semiconductor structure according to any one of claims 1 to 4, further comprising a first electrical connection layer (106), wherein the first electrical connection layer is electrically connected to a plurality of first conductive structures spaced apart along the second direction, and the first electrical connection layer is located above the plurality of first conductive structures.

15. The semiconductor structure according to claim 6, wherein along the first direction, a first length (L1) of the first conductive structure is less than a second length (L2) of the first electrode; the semiconductor structure further comprises a second isolation layer (115), wherein the second isolation layer is located on at least one side of the first conductive structure along the first direction, and the second isolation layer is in contact with a sidewall of the first electrode.

16. The semiconductor structure according to claim 8, further comprising: a first conductive plug (107) located on the first conductive structure and electrically connected to the first conductive structure;
a second conductive plug (117) located on the second conductive structure and electrically connected to the second conductive structure; and
a second electrical connection layer (116) located on the first conductive plug and the second conductive plug and electrically connected to the first conductive plug and the second conductive plug.

17. The semiconductor structure according to claim 1, wherein the transistor comprises a semiconductor layer (112) extending along the first direction, the semiconductor layer comprises a first surface (e) and a second surface (f) directly opposite to each other along the first direction, and the first surface is in contact with the capacitor;
the semiconductor structure further comprises:
a bit line structure (108) in contact with the second surface; and
a word line structure (109) located on a side surface of the semiconductor layer, wherein
the word line structure extends along the second direction, and the bit line structure extends along the third direction; or the word line structure extends along the third direction, and the bit line structure extends along the second direction.

18. A method for manufacturing a semiconductor structure, comprising:
providing a substrate (100);
forming a memory cell group (101) on the substrate, wherein the memory cell group comprises a plurality of vertically stacked memory cells (111), each one of the plurality of memory cells comprises a transistor (102) and a capacitor (103), and the capacitor extends along a first direction (X) parallel to the substrate; and
forming a first conductive structure (104), wherein the first conductive structure is located on a first side surface (a) of the memory cell group, the first conductive structure and the memory cell group are arranged along a second direction (Y) parallel to the substrate, the first conductive structure extends along a third direction (Z) perpendicular to the substrate, the first conductive structure is coupled to a plurality of capacitors in the memory cell group, and the first direction and the second direction intersect with each other.

19. The manufacturing method according to claim 18, wherein forming the memory cell group on the substrate comprises:
forming a stack structure (110) on the substrate, wherein the stack structure comprises a first sacrificial layer (120) and a second sacrificial layer (130) alternately stacked along the third direction;
patterning the second sacrificial layer to form capacitor grooves (131) extending along the first direction, wherein a plurality of capacitor grooves are spaced apart at least along the second direction;
forming first electrodes respectively in the capacitor grooves, wherein a plurality of first electrodes are spaced apart along the second direction and the third direction, and the first direction and the second direction intersect with each other and are both parallel to the substrate; and
forming a first dielectric layer (123), wherein the first dielectric layer is located on a sidewall of the first electrode, wherein
after the first conductive structure is formed, the first conductive structure comes in contact with the first dielectric layer.

20. The manufacturing method according to claim 19, wherein forming the first conductive structure comprises:
etching the stack structure to form a first through hole (139) penetrating through the stack structure in the third direction, wherein the first through hole is located between first electrodes adjacent to each other along the second direction; and
forming the first conductive structure in the first through hole.

21. The manufacturing method according to claim 20, wherein the first through hole exposes a sidewall of the first electrode and a sidewall of the first sacrificial layer, and the manufacturing method further comprises:
performing lateral etching along the first through hole to remove the first sacrificial layer exposed by the first through hole and form an intercommunication groove (121), wherein the intercommunication groove is located between first electrodes adjacent to each other along the third direction, and the intercommunication groove is in communication with two first through holes adjacent to each other along the second direction;
the formed first dielectric layer further covers an inner wall of the intercommunication groove;
the step of forming the first conductive structure in the first through hole further comprises: forming a conductive protrusion part (114) in the intercommunication groove.

22. The manufacturing method according to claim 19, wherein patterning the second sacrificial layer comprises:
etching the stack structure to form a second through hole (149) penetrating through the stack structure in the third direction, wherein the second through hole exposes the first sacrificial layer and the second sacrificial layer; and
performing lateral etching along the second through hole to remove a part of the second sacrificial layer and form the capacitor grooves, wherein
forming the first electrodes respectively in the capacitor grooves comprises: forming the first electrodes conformally covering inner walls of the capacitor grooves, respectively, wherein the first electrode is a cup-shaped structure with an opening toward the first direction;
the manufacturing method further comprises: forming a second dielectric layer (153) at least conformally covering an inner wall of the first electrode; and
forming first conductive parts (143) and a second conductive structure (163) on a surface of the second dielectric layer, wherein the first conductive parts are in a one-to-one correspondence with the first electrodes, pass through the opening, and are respectively embedded in the first electrodes, and the second conductive structure fills up the second through hole.

23. The manufacturing method according to claim 20, wherein a plurality of first through holes are spaced apart at least along the second direction; after the first conductive structure is formed in the first through hole, the manufacturing method further comprises: forming a first electrical connection layer (106) on top surfaces of a plurality of first conductive structures, wherein the first electrical connection layer is electrically connected to a plurality of first conductive structures spaced apart along the second direction.
